# EUROPEAN PATENT SPECIFICATION

(11) **EP 3 667 703 B1**
(45) Date of publication and mention of the grant of the patent: **15.10.2025**
(21) Application number: 19211085.6
(22) Date of filing: 25.11.2019
(51) Int. Cl.: H01L 21/02, H01L 21/67

(54) **SUBSTRATE PROCESSING METHOD**
SUBSTRATVERARBEITUNGSVERFAHREN
PROCÉDÉ DE TRAITEMENT DE SUBSTRAT

(30) Priority: 14.12.2018 JP 2018234733
(43) Date of publication of application: 17.06.2020
(73) Proprietor: SCREEN Holdings Co., Ltd., Kyoto-shi, Kyoto 602-8585 (JP)
(72) Inventor: Yoshida, Yukifumi, Kyoto-shi, Kyoto 602-8585 (JP); Ueda, Dai, Kyoto-shi, Kyoto 602-8585 (JP)
(74) Representative: Goddar, Heinz J.

(56) References cited:
- EP-A1- 3 894 491
- EP-A1- 3 894 534
- JP-A- 2018 110 220
- US-A1- 2015 128 994

## Description

### BACKGROUND OF THE INVENTION

### 1. Field of the Invention

The present invention relates to a substrate processing method. Examples of substrates to be processed include substrates such as semiconductor wafers, substrates for liquid crystal display devices, substrates for FPDs (flat panel displays), such as organic EL (electroluminescence) display devices, etc., substrates for optical disks, substrates for magnetic disks, substrates for magneto-optical disks, substrates for photomasks, ceramic substrates, substrates for solar cells, etc.

### 2. Description of the Related Art

In a manufacturing process of semiconductor devices, a cleaning step is executed in order to remove various contaminants attached to a substrate, residue of a processing liquid or a resist, etc., used in a prior step, and various particles, etc. (these may hereinafter be referred to collectively as the "object to be removed").

In the cleaning step, in general, a cleaning liquid, such as deionized water (DIW), etc., is supplied to the substrate to remove the object to be removed by physical actions of the cleaning liquid, or a chemical liquid that chemically reacts with the object to be removed is supplied to the substrate to chemically remove the object to be removed.

However, progress is being made in making an uneven pattern formed on a substrate finer and more complex. Therefore, it is becoming difficult to remove an object to be removed using a cleaning liquid or a chemical liquid while suppressing damage to the uneven pattern.

Thus, a method has been proposed where a processing liquid, containing a solute and a solvent having volatility, is supplied to an upper surface of a substrate, the processing liquid is solidified or cured to form a processing film, and thereafter, the processing film is dissolved and removed (refer to United States Patent Application Publication No. 2014/041685 and United States Patent Application Publication No. 2015/128994).

With the method described above, an object to be removed is pulled away from the substrate when the processing liquid is solidified or cured to form the processing film. The object to be removed that has been pulled away is then held inside the processing film.

Next, a dissolution processing liquid is supplied to the upper surface of the substrate. Since the processing film is thereby dissolved on the substrate and removed, the object to be removed is removed from the upper surface of the substrate together with dissolved matter of the processing film (refer to United States Patent Application Publication No. 2014/041685).

Alternatively, there is also a case in which a peeling processing liquid is supplied to an upper surface of a substrate. Thereby, the processing film is peeled from the upper surface of the substrate. The dissolution processing liquid is then supplied by which the processing film is dissolved on the substrate (refer to United States Patent Application Publication No. 2015/128994).

JP 2018 110220 A discloses a substrate processing method, wherein a processing film is removed from the surface of the substrate in the state where an object to be removed is held by the processing film.

### SUMMARY OF THE INVENTION

However, with both the method disclosed in United States Patent Application Publication No. 2014/041685 and the method disclosed in United States Patent Application Publication No. 2015/128994, the processing film is dissolved on the substrate. Therefore, the object to be removed may fall off from the processing film on the substrate and the fallen object to be removed may become reattached to the substrate. There is thus a risk that the object to be removed may not be efficiently removed from the substrate. A method for removing the processing film from the substrate in the state where the object to be removed is held by the processing film is thus being demanded.

However, a peeling liquid capable of peeling and removing the processing film from a surface of substrate in a state where the removal object is held by the processing film is comparatively expensive. When the peeling liquid is supplied toward the upper surface of the substrate, the peeling liquid will be consumed in a large amount and cost may thus increase.

Thus, an object of the present invention is to provide a substrate processing method by which an object to be removed present on a surface of a substrate can be removed efficiently while suppressing cost increase.

The present invention provides a substrate processing method according to claim 1.

According to the present method, by putting the dissolving and peeling liquid forming liquid, supplied to the surface of the substrate, and the processing film in contact, the dissolving and peeling liquid that peels the processing film from the surface of the substrate is formed on the substrate. By the dissolving and peeling liquid that is formed spontaneously on the substrate, the processing film in the state of holding the object to be removed is peeled from the surface of the substrate. By then continuing the supply of the dissolving and peeling liquid forming liquid, the processing film can be removed from the surface of the substrate in the state where the object to be removed is held by the processing film. That is, the object to be removed can be removed from the surface of the substrate by just supplying the dissolving and peeling liquid forming liquid without supplying the dissolving and peeling liquid toward the surface of the substrate. That is, the object to be removed can be removed from the surface of the substrate without consuming the comparatively expensive dissolving and peeling liquid in a large amount. The removal object present on the surface of the substrate can thus be removed efficiently while suppressing cost increase.

According to the present invention, the solute has a dissolving and peeling liquid forming substance. Also, the processing film forming step includes a step of forming the processing film having the dissolving and peeling liquid forming substance in a solid state. Also, the dissolving and peeling liquid includes a step of dissolving the dissolving and peeling liquid forming substance that is in the solid state inside the processing film in the dissolving and peeling liquid forming liquid supplied to the surface of the substrate to form the dissolving and peeling liquid.

According to the present method, the dissolving and peeling liquid is formed by dissolving the dissolving and peeling liquid forming substance, that is in the solid state inside the processing film, in the dissolving and peeling liquid forming liquid. The dissolving and peeling liquid can thus be formed in a vicinity of the processing film by dissolving the dissolving and peeling liquid forming substance in the dissolving and peeling liquid forming liquid in the vicinity of the processing film. The dissolving and peeling liquid, that is comparatively high in concentration of the dissolving and peeling liquid forming substance before the dissolving and peeling liquid forming substance eluted into the dissolving and peeling liquid forming liquid diffuses uniformly throughout the entire dissolving and peeling liquid forming liquid, can thus be made to act on the processing film. The processing film can thereby be peeled efficiently and the object to be removed present on the surface of the substrate can be removed efficiently.

As with the dissolving and peeling liquid, the dissolving and peeling liquid forming substance required for forming the dissolving and peeling liquid is also comparatively expensive. Also, a time required to supply an amount of the processing liquid required to form the processing film to the substrate is shorter than a time required for peeling and removing the processing film from the substrate. Thus, in the present method, the processing liquid that contains the dissolving and peeling liquid forming substance is supplied to the substrate for forming the processing film and the dissolving and peeling liquid forming liquid that does not contain the dissolving and peeling liquid forming substance is supplied to the substrate for peeling and removing the processing film. A supply time (consumption amount) of the dissolving and peeling liquid forming substance to the substrate can thus be reduced in comparison to a method where a processing liquid that does not contain the dissolving and peeling liquid forming substance is supplied to the substrate for forming the processing film and the dissolving and peeling liquid (the dissolving and peeling liquid forming liquid with the dissolving and peeling liquid forming substance dissolved therein) is supplied to the substrate for peeling and removing the processing film. Cost increase can thus be suppressed.

Consequently, the object to be removed present on the surface of the substrate can be removed efficiently while suppressing cost increase.

According to the present invention, the dissolving and peeling liquid is an alkaline liquid. The alkaline liquid, although capable of peeling the processing film efficiently, is comparatively expensive. Now, with the method where the alkaline liquid is formed by contact of the dissolving and peeling liquid forming liquid and the processing film, the alkaline liquid can be formed spontaneously on the substrate. The object to be removed can thus be removed from the surface of the substrate by just supplying the dissolving and peeling liquid forming liquid without supplying the alkaline liquid toward the surface of the substrate. That is, the object to be removed can be removed from the surface of the substrate without consuming the comparatively expensive alkaline liquid in a large amount. A consumption amount of the alkaline liquid can thus be reduced and therefore cost increase can be suppressed. The object to be removed present on the surface of the substrate can thus be removed efficiently while suppressing cost increase.

According to the present invention, the dissolving and peeling liquid forming liquid is pure water, carbonated water, or ammonia water of dilute concentration. The processing film can thus be peeled and removed from the surface of the substrate using pure water, which is comparatively inexpensive, as the dissolving and peeling liquid forming liquid. The object to be removed present on the surface of the substrate can thus be removed efficiently while suppressing cost increase.

According to the present invention, the peeling step includes a penetrating hole forming step of supplying the dissolving and peeling liquid forming liquid to the surface of the substrate to dissolve the processing film partially and form a penetrating hole in the processing film.

According to the present method, by supplying the dissolving and peeling liquid forming liquid to the surface of the substrate, the processing film is partially dissolved to form the penetrating hole in the processing film. By the penetrating hole being formed in the processing film, the dissolving and peeling liquid is enabled to readily reach a vicinity of the surface of the substrate. Therefore, the dissolving and peeling liquid can be made to act on an interface between the processing film and the substrate to enable the processing film to be peeled efficiently from the surface of the substrate. On the other hand, although the processing film is partially dissolved for forming the penetrating hole, a remaining portion thereof is kept in a solid state, that is, in the state of holding the object to be removed. Consequently, the processing film can be peeled quickly from the surface of the substrate and the object to be removed can be removed efficiently together with the processing film from the surface of the substrate.

In a variation of the present invention, the solute has a high solubility substance and a low solubility substance that is lower in solubility in the dissolving and peeling liquid than the high solubility substance. Also, the processing film forming step includes a step of forming the processing film having the high solubility substance and the low solubility substance in solid states. Also, the penetrating hole forming step includes a step of dissolving the high solubility substance that is in the solid state inside the processing film in the dissolving and peeling liquid formed on the substrate to form the penetrating hole in the processing film.

According to the present method, the high solubility substance is higher in solubility in the dissolving and peeling liquid than the low solubility substance. The penetrating hole can thus be formed reliably in the processing film by the dissolving and peeling liquid dissolving the high solubility substance that is in the solid state inside the processing film. On the other hand, the low solubility substance inside the processing film is kept in the solid state without being dissolved. Therefore, the dissolving and peeling liquid can be made to act on an interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

In another variation of the present invention, a solubility of the low solubility substance in the dissolving and peeling liquid forming liquid is lower than a solubility of the high solubility substance in the dissolving and peeling liquid forming liquid. Also, the penetrating hole forming step includes a step of dissolving the high solubility substance, which is in the solid state inside the processing film, in the dissolving and peeling liquid forming liquid supplied to the surface of the substrate to form the penetrating hole in the processing film.

According to the present method, the high solubility substance is higher in solubility in the dissolving and peeling liquid forming liquid than the low solubility substance. The penetrating hole can thus be formed reliably in the processing film by the dissolving and peeling liquid forming liquid dissolving the high solubility substance that is in the solid state inside the processing film. On the other hand, the low solubility substance in the solid state inside the processing film is kept in the solid state without being dissolved. Therefore, the dissolving and peeling liquid can be made to act on the interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

In the preferred embodiment of the present invention, the solute has a high solubility substance and a low solubility substance that is lower in solubility in the dissolving and peeling liquid forming liquid than the high solubility substance. Also, the processing film forming step includes a step of forming the processing film having the high solubility substance and the low solubility substance in solid states. Also, the penetrating hole forming step includes a step of dissolving the high solubility substance, which is in the solid state inside the processing film, in the dissolving and peeling liquid forming liquid supplied to the surface of the substrate to form the penetrating hole in the processing film.

According to the present method, the high solubility substance is higher in solubility in the dissolving and peeling liquid forming liquid than the low solubility substance. The penetrating hole can thus be formed reliably in the processing film by the dissolving and peeling liquid forming liquid dissolving the high solubility substance that is in the solid state inside the processing film. On the other hand, the low solubility substance inside the processing film is kept in the solid state without being dissolved. Therefore, the dissolving and peeling liquid can be made to act on the interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

A preferred embodiment of the present invention provides a substrate processing method including a processing liquid supplying step of supplying a processing liquid having a solute that contains an alkaline component and a solvent toward a surface of a substrate, a processing film forming step of solidifying or curing the processing liquid supplied to the surface of the substrate to form, on the surface of the substrate, a processing film that contains the alkaline component and holds an object to be removed present on the surface of the substrate, a dissolving and peeling step of supplying pure water to the surface of the substrate to put the pure water in contact with the processing film to elute the alkaline component from the processing film into the pure water and form an alkaline aqueous solution, and peeling the processing film, in the state of holding the object to be removed, from the surface of the substrate by the alkaline aqueous solution, and a removing step of continuing the supply of the pure water, after the peeling of the processing film, to wash away and remove the processing film from the surface of the substrate in the state where the object to be removed is held by the processing film.

According to the present method, by putting the pure water, supplied to the surface of the substrate, and the processing film in contact, the alkaline component is eluted into the pure water from the processing film and the alkaline aqueous solution is formed (prepared) on the substrate. By the alkaline aqueous solution that is formed spontaneously on the substrate, the processing film in the state of holding the object to be removed is peeled from the surface of the substrate. By then continuing the supply of the pure water, the processing film can be removed from the surface of the substrate in the state where the object to be removed is held by the processing film. That is, the object to be removed can be removed from the surface of the substrate by just supplying the pure water without supplying the alkaline aqueous solution toward the surface of the substrate. That is, the object to be removed can be removed from the surface of the substrate without consuming the comparatively expensive alkaline aqueous solution in a large amount. The object to be removed present on the surface of the substrate can thus be removed efficiently while suppressing cost increase.

A substrate processing apparatus not forming part of the invention is provided. The substrate processing apparatus includes a processing liquid supplying unit that supplies a processing liquid having a solute and a solvent to a surface of a substrate, a solid forming unit that solidifies or cures the processing liquid, a dissolving and peeling liquid forming liquid supplying unit that supplies a dissolving and peeling liquid forming liquid to the surface of the substrate, and a controller that controls the processing liquid supplying unit, the solid forming unit, and the dissolving and peeling liquid forming liquid supplying unit.

The controller is programmed to execute a processing liquid supplying step of supplying the processing liquid from the processing liquid supplying unit to the surface of the substrate, a processing film forming step of making the solid forming unit solidify or cure the processing liquid supplied to the surface of the substrate to form, on the surface of the substrate, a processing film that holds an object to be removed present on the surface of the substrate, a dissolving and peeling step of supplying the dissolving and peeling liquid forming liquid from the dissolving and peeling liquid forming liquid supplying unit to the surface of the substrate to put the dissolving and peeling liquid forming liquid in contact with the processing film and form a dissolving and peeling liquid and peeling the processing film, in the state of holding the object to be removed, from the surface of the substrate by the dissolving and peeling liquid, and a removing step of continuing the supply of the dissolving and peeling liquid forming liquid from the dissolving and peeling liquid forming liquid supplying unit, after the peeling of the processing film, to remove the processing film from the surface of the substrate in the state where the object to be removed is held by the processing film.

According to the present configuration, by putting the dissolving and peeling liquid forming liquid, supplied to the surface of the substrate, and the processing film in contact, the dissolving and peeling liquid that peels the processing film from the surface of the substrate is formed on the substrate. By the dissolving and peeling liquid that is formed spontaneously on the substrate, the processing film in the state of holding the object to be removed is peeled from the surface of the substrate. By then continuing the supply of the dissolving and peeling liquid forming liquid, the processing film can be removed from the surface of the substrate in the state where the object to be removed is held by the processing film. That is, the object to be removed can be removed from the surface of the substrate by just supplying the dissolving and peeling liquid forming liquid without supplying the peeling liquid toward the surface of the substrate. That is, the object to be removed can be removed from the surface of the substrate without consuming the comparatively expensive peeling liquid in a large amount. The object to be removed present on the surface of the substrate can thus be removed efficiently while suppressing cost increase.

The solute has a dissolving and peeling liquid forming substance. Also, in the processing film forming step, the processing film having the dissolving and peeling liquid forming substance in a solid state is formed. Also, in the dissolving and peeling step, the dissolving and peeling liquid forming liquid supplied to the surface of the substrate dissolves the dissolving and peeling liquid forming substance in the solid state inside the processing film to form the dissolving and peeling liquid.

According to the present configuration, the dissolving and peeling liquid is formed by dissolving the dissolving and peeling liquid forming substance, that is in the solid state inside the processing film, in the dissolving and peeling liquid forming liquid. The dissolving and peeling liquid can thus be formed in a vicinity of the processing film by dissolving the dissolving and peeling liquid forming substance in the dissolving and peeling liquid forming liquid in the vicinity of the processing film. The dissolving and peeling liquid, that is comparatively high in concentration of the dissolving and peeling liquid forming substance before the dissolving and peeling liquid forming substance eluted into the dissolving and peeling liquid forming liquid diffuses uniformly throughout the entire dissolving and peeling liquid forming liquid, can thus be made to act on the processing film. The processing film can thereby be peeled efficiently and the object to be removed present on the surface of the substrate can be removed efficiently.

As with the dissolving and peeling liquid, the dissolving and peeling liquid forming substance required for forming the dissolving and peeling liquid is also comparatively expensive. Also, a time required to supply an amount of the processing liquid required to form the processing film to the substrate is shorter than a time required for peeling and removing the processing film from the substrate. Thus, in the present configuration, the processing liquid that contains the dissolving and peeling liquid forming substance is supplied to the substrate for forming the processing film and the dissolving and peeling liquid forming liquid that does not contain the dissolving and peeling liquid forming substance is supplied to the substrate for peeling and removing the processing film. A supply time (consumption amount) of the dissolving and peeling liquid forming substance can thus be reduced in comparison to an configuration where a processing liquid that does not contain the dissolving and peeling liquid forming substance is supplied to the substrate for forming the processing film and the dissolving and peeling liquid (the dissolving and peeling liquid forming liquid with the dissolving and peeling liquid forming substance dissolved therein) is supplied to the substrate for peeling and removing the processing film. Cost increase can thus be suppressed.

Consequently, the object to be removed present on the surface of the substrate can be removed efficiently while suppressing cost increase.

The dissolving and peeling liquid is an alkaline liquid. The alkaline liquid, although capable of peeling the processing film efficiently, is comparatively expensive. Now, with the configuration where the alkaline liquid is formed by contact of the dissolving and peeling liquid forming liquid and the processing film, the alkaline liquid can be formed spontaneously on the substrate. The object to be removed can thus be removed from the surface of the substrate by just supplying the dissolving and peeling liquid forming liquid without supplying the alkaline liquid toward the surface of the substrate. That is, the object to be removed can be removed from the surface of the substrate without consuming the comparatively expensive alkaline liquid in a large amount. A consumption amount of the alkaline liquid can thus be reduced and therefore cost increase can be suppressed. The object to be removed present on the surface of the substrate can thus be removed efficiently while suppressing cost increase.

The dissolving and peeling liquid forming liquid supplying unit supplies pure water as the dissolving and peeling liquid forming liquid to the surface of the substrate. The processing film can thus be peeled and removed from the surface of the substrate using pure water, which is comparatively inexpensive, as the dissolving and peeling liquid forming liquid. The object to be removed present on the surface of the substrate can thus be removed efficiently while suppressing cost increase.

In the dissolving and peeling step, the dissolving and peeling liquid forming liquid is supplied to the surface of the substrate to dissolve the processing film partially and form a penetrating hole in the processing film.

According to the present configuration, by supplying the dissolving and peeling liquid forming liquid to the surface of the substrate, the processing film is partially dissolved to form the penetrating hole in the processing film. By the penetrating hole being formed in the processing film, the dissolving and peeling liquid is enabled to readily reach a vicinity of the surface of the substrate. Therefore, the dissolving and peeling liquid can be made to act on an interface between the processing film and the substrate to enable the processing film to be peeled efficiently from the surface of the substrate. On the other hand, although the processing film is partially dissolved for forming the penetrating hole, a remaining portion thereof is kept in a solid state, that is, in the state of holding the object to be removed. Consequently, the processing film can be peeled quickly from the surface of the substrate and the object to be removed can be removed efficiently together with the processing film from the surface of the substrate.

In variation of the present invention, the solute has a high solubility substance and a low solubility substance that is lower in solubility in the dissolving and peeling liquid than the high solubility substance. Also, in the processing film forming step, the processing film having the high solubility substance and the low solubility substance in solid states is formed. Also, in the dissolving and peeling step, the dissolving and peeling liquid formed on the substrate dissolves the high solubility substance, that is in the solid state inside the processing film, to form the penetrating hole in the processing film.

According to the present configuration, the high solubility substance is higher in solubility in the dissolving and peeling liquid than the low solubility substance. The penetrating hole can thus be formed reliably in the processing film by the dissolving and peeling liquid dissolving the high solubility substance that is in the solid state inside the processing film. On the other hand, the low solubility substance inside the processing film is kept in the solid state without being dissolved. Therefore, the dissolving and peeling liquid can be made to act on an interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

In the other preferred embodiment of the present invention, a solubility of the low solubility substance in the dissolving and peeling liquid forming liquid is lower than a solubility of the high solubility substance in the dissolving and peeling liquid forming liquid. Also, in the processing film forming step, the dissolving and peeling liquid forming liquid, supplied to the surface of the substrate, dissolves the high solubility substance in the solid state inside the processing film to form the penetrating hole in the processing film.

According to the present configuration, the high solubility substance is higher in solubility in the dissolving and peeling liquid forming liquid than the low solubility substance. The penetrating hole can thus be formed reliably in the processing film by the dissolving and peeling liquid forming liquid dissolving the high solubility substance that is in the solid state inside the processing film. On the other hand, the low solubility substance in the solid state inside the processing film is kept in the solid state without being dissolved. Therefore, the dissolving and peeling liquid can be made to act on the interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

In another variation of the present invention, the solute has a high solubility substance and a low solubility substance that is lower in solubility in the dissolving and peeling liquid forming liquid than the high solubility substance. Also, in the processing film forming step, the processing film having the high solubility substance and the low solubility substance in solid states is formed. Also, in the dissolving and peeling step, the dissolving and peeling liquid forming liquid supplied to the surface of the substrate dissolves the high solubility substance in the solid state inside the processing film to form the penetrating hole in the processing film.

According to the present configuration, the high solubility substance is higher in solubility in the dissolving and peeling liquid forming liquid than the low solubility substance. The penetrating hole can thus be formed reliably in the processing film by the dissolving and peeling liquid forming liquid dissolving the high solubility substance that is in the solid state inside the processing film. On the other hand, the low solubility substance inside the processing film is kept in the solid state without being dissolved. Therefore, the dissolving and peeling liquid can be made to act on the interface between the low solubility substance in the solid state and the substrate while the object to be removed is held by the low solubility substance in the solid state. Consequently, the processing film can be peeled quickly from the surface of the substrate and the object to be removed can be removed efficiently together with the processing film from the surface of the substrate.

Another substrate processing apparatus not forming part of the invention is provided. Said substrate processing apparatus includes a processing liquid supplying unit that supplies a processing liquid having a solute that contains an alkaline component and a solvent to a surface of a substrate, a solid forming unit that solidifies or cures the processing liquid, a pure water supplying unit that supplies pure water to the surface of the substrate, and a controller that controls the processing liquid supplying unit, the solid forming unit, and the pure water supplying unit.

The controller is programmed to execute a processing liquid supplying step of supplying the processing liquid from the processing liquid supplying unit to the surface of the substrate, a processing film forming step of making the solid forming unit solidify or cure the processing liquid supplied to the surface of the substrate to form, on the surface of the substrate, a processing film that contains the alkaline component and holds an object to be removed present on the surface of the substrate, a peeling step of supplying the pure water from the pure water supplying unit to the surface of the substrate to put the pure water in contact with the processing film to elute the alkaline component from the processing film into the pure water and form an alkaline aqueous solution, and peeling the processing film, in the state of holding the object to be removed, a from the surface of the substrate by the alkaline aqueous solution, and a removing step of continuing the supply of the pure water from the pure water supplying unit, after the peeling of the processing film, to remove the processing film from the surface of the substrate in the state where the object to be removed is held by the processing film.

According to the present configuration, by putting the pure water, supplied to the surface of the substrate, and the processing film in contact, the alkaline component is eluted into the pure water from the processing film and the alkaline aqueous solution is formed (prepared) on the substrate. By the alkaline aqueous solution that is formed spontaneously on the substrate, the processing film in the state of holding the object to be removed is peeled from the surface of the substrate. By then continuing the supply of the pure water, the processing film can be removed from the surface of the substrate in the state where the object to be removed is held by the processing film. That is, the object to be removed can be removed from the surface of the substrate by just supplying the pure water without supplying the alkaline aqueous solution toward the surface of the substrate. That is, the object to be removed can be removed from the surface of the substrate without consuming the comparatively expensive alkaline aqueous solution in a large amount. The object to be removed present on the surface of the substrate can thus be removed efficiently while suppressing cost increase.

The above and other elements, features, steps, characteristics and advantages of the present invention will become more apparent from the following detailed description of the preferred embodiments with reference to the attached drawings.

### BRIEF DESCRIPTION OF THE DRAWINGS

FIG. 1 is a schematic plan view of a layout of a substrate processing apparatus not forming part of the present invention.
FIG. 2 is a schematic partial sectional view of the general configuration of a processing unit included in the substrate processing apparatus.
FIG. 3 is a block diagram of the electrical configuration of a main portion of the substrate processing apparatus.
FIG. 4 is a flowchart for describing an example of substrate processing by the substrate processing apparatus.
FIG. 5A is a schematic view for describing conditions of a processing liquid supplying step (step S5) in the substrate processing.
FIG. 5B is a schematic view for describing conditions of a film thinning step (step S6) in the substrate processing.
FIG. 5C is a schematic view for describing conditions of a heating step (step S7) in the substrate processing.
FIG. 5D is a schematic view for describing conditions of a peeling/removing step (step S8) in the substrate processing.
FIG. 5E is a schematic view for describing conditions of a second rinsing step (step S9) in the substrate processing.
FIG. 5F is a schematic view for describing conditions of a second organic solvent supplying step (step S10) in the substrate processing.
FIG. 5G is a schematic view for describing conditions of a spin drying step (step S11) in the substrate processing.
FIG. 6A is a schematic sectional view for describing conditions in a vicinity of a surface of a substrate after the heating step (step S7).
FIG. 6B is a schematic sectional view for describing conditions in the vicinity of the surface of the substrate during execution of the peeling/removing step (step S8).
FIG. 6C is a schematic sectional view for describing conditions in the vicinity of the surface of the substrate during execution of the peeling/removing step (step S8).
FIG. 6D is a schematic sectional view for describing conditions in the vicinity of the surface of the substrate during execution of the peeling/removing step (step S8).
FIG. 7 is a schematic partial sectional view of the general configuration of a processing unit included in a substrate processing apparatus not forming part of the invention.

### DETAILED DESCRIPTION OF THE PREFERRED EMBODIMENTS

In the present Specification, unless restrictedly mentioned otherwise, the singular form includes the plural form and "one" and "the" signify "at least one." In the present Specification, unless mentioned otherwise, an element of a concept is capable of being expressed by a plurality of types and when an amount (for example, mass % or mole %) thereof is indicated, the amount signifies the sum of the plurality of types.

"And/or" includes all combinations of the elements and also includes use as a singular element.

In the present Specification, when a numerical range is indicated using "~" or "-," unless restrictedly mentioned otherwise, both endpoints are included and the units are the same. For example, 5 ~ 25 mole % signifies not less than 5 mole % and not more than 25 mole %.

In the present Specification, expressions of "C_{x~y}," "Cₓ~C_{y}," and "Cₓ," etc., indicate the number of carbons in a molecule or a substituent. For example, C_{1~6} alkyl indicates an alkyl chain (methyl, ethyl, propyl, butyl, pentyl, hexyl, etc.) having not less than one and not more than six carbons.

In the present Specification, when a polymer has plural types of repeating units, these repeating units are copolymerized. Unless restrictedly mentioned otherwise, the copolymerization may be any one of alternating copolymerization, random copolymerization, block copolymerization, graft copolymerization or a mixture thereof. When a polymer and a resin is expressed by a structural formula, n, m, etc., which are written together in parentheses indicate the number of repetitions.

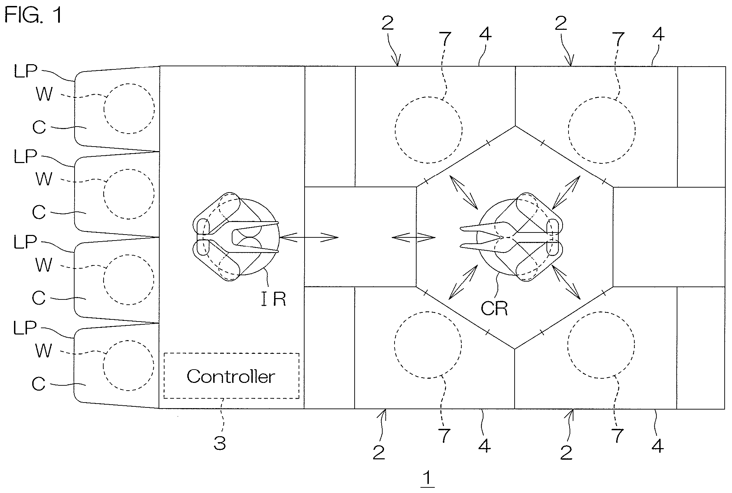

FIG. 1 is a schematic plan view of a layout of a substrate processing apparatus 1 not forming part of the present invention.

The substrate processing apparatus 1 is a single substrate processing type apparatus that processes a substrate W, such as a silicon wafer, etc., one at a time. In the present preferred embodiment, the substrate W is a disk-shaped substrate.

The substrate processing apparatus 1 includes a plurality of processing units 2 for processing substrates W with fluids, load ports LP on which are placed carriers C that house a plurality of the substrates W to be processed by the processing units 2, transfer robots IR and CR that transfer the substrates W between the load ports LP and the processing units 2, and a controller 3 that controls the substrate processing apparatus 1.

The transfer robot IR transfers the substrates W between the carriers C and the transfer robot CR. The transfer robot CR transfers the substrates W between the transfer robot IR and the processing units 2. The plurality of processing units 2 have, for example, the same configuration. Although the details will be described later, a processing fluid supplied to the substrate W inside the processing unit 2 includes a chemical liquid, a rinse liquid, a processing liquid, a dissolving and peeling liquid forming liquid, a heating medium, an inert gas, etc.

Each processing unit 2 includes a chamber 4 and a processing cup 7 disposed inside the chamber 4 and executes processing of the substrate W inside the processing cup 7. An inlet/outlet (not shown) for carrying in the substrates W and carrying out the substrates W by the transfer robot CR is formed at the chamber 4. The chamber 4 is provided with a shutter unit (not shown) for opening/closing the inlet/outlet.

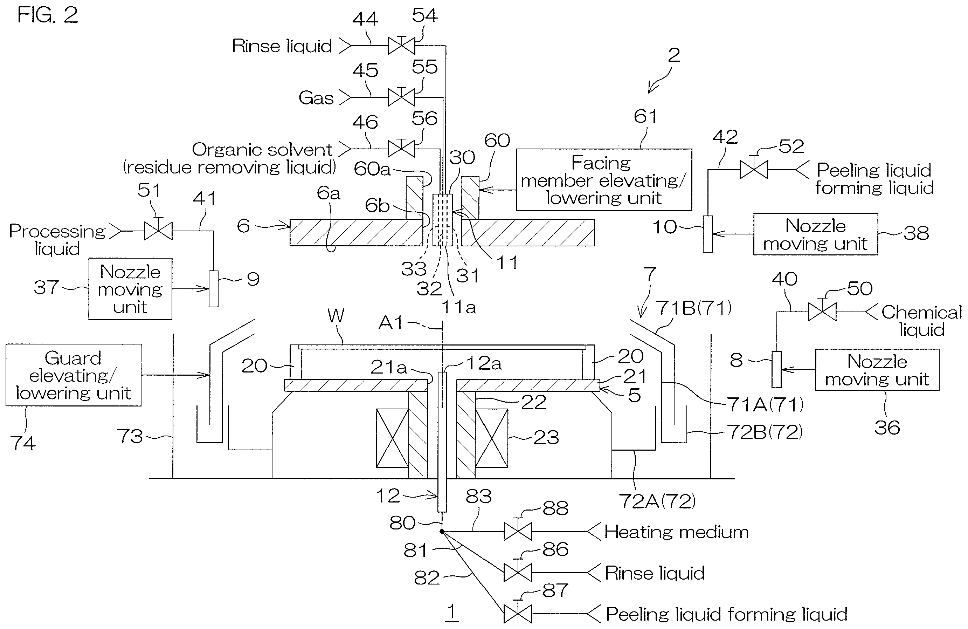

FIG. 2 is a schematic view for describing an configuration example of the processing unit 2. The processing unit 2 includes a spin chuck 5, a facing member 6, a processing cup 7, a first moving nozzle 8, a second moving nozzle 9, a third moving nozzle 10, a central nozzle 11, and a lower surface nozzle 12.

The spin chuck 5 rotates the substrate W around a vertical rotational axis A1 (a vertical axis), passing through a central portion of the substrate W, while holding the substrate W horizontally. The spin chuck 5 includes a plurality of chuck pins 20, a spin base 21, a rotating shaft 22 and a spin motor 23.

The spin base 21 has a disk shape oriented along a horizontal direction. On an upper surface of the spin base 21, a plurality of chuck pins 20 that grip a peripheral edge of the substrate W are disposed at intervals in a circumferential direction of the spin base 21. The spin base 21 and the plurality of chuck pins 20 constitute a substrate holding unit that holds the substrate W horizontally. The substrate holding unit is also referred to as a substrate holder.

The rotating shaft 22 extends in a vertical direction along the rotational axis A1. An upper end portion of the rotating shaft 22 is coupled to a lower surface center of the spin base 21. The spin motor 23 applies a rotating force to the rotating shaft 22. The spin base 21 is rotated by the rotating shaft 22 being rotated by the spin motor 23. The substrate W is thereby rotated around the rotational axis A1. The spin motor 23 is an example of a substrate rotating unit that rotates the substrate W around the rotational axis A1.

The facing member 6 faces the substrate W, held by the spin chuck 5, from above. The facing member 6 is formed to a disk shape having substantially the same diameter as or a diameter equal to or larger than that of the substrate W. The facing member 6 has a facing surface 6a that faces an upper surface (surface on the upper side) of the substrate W. The facing surface 6a is disposed substantially along a horizontal surface higher than the spin chuck 5.

A hollow shaft 60 is fixed to the facing member 6 at an opposite side to the facing surface 6a. A communicating hole 6b that penetrates up and down through the facing member 6 and is in communication with an internal space 60a of the hollow shaft 60 is formed at a portion of the facing member 6 overlapping with the rotational axis A1 in plan view.

The facing member 6 blocks an atmosphere inside a space between the facing surface 6a and the upper surface of the substrate W from an atmosphere outside the space. The facing member 6 is thus also referred to as a blocking plate.

The processing unit 2 further includes a facing member elevating/lowering unit 61 that drives elevation and lowering of the facing member 6. The facing member elevating/lowering unit 61 is capable of positioning the facing member 6 at any position (height) from a lower position to an upper position. The lower position is a position within a movable range of the facing member 6 at which the facing surface 6a is positioned most proximate to the substrate W. The upper position is a position within the movable range of the facing member 6 at which the facing surface 6a is separated farthest from the substrate W.

The facing member elevating/lowering unit 61 includes, for example, a ball-screw mechanism (not shown) coupled to a supporting member (not shown) that supports the hollow shaft 60 and an electric motor (not shown) that applies a driving force to the ball-screw mechanism. The facing member elevating/lowering unit 61 is also referred to as a facing member lifter (blocking plate lifter).

The processing cup 7 includes a plurality of guards 71 that receive liquid splashed outside from the substrate W held by the spin chuck 5, a plurality of cups 72 that receive liquid guided downward by the plurality of guards 71, and a circular-cylindrical outer wall member 73 that surrounds the plurality of guards 71 and the plurality of cups 72.

In the present preferred variation, there is shown an example where two guards 71 (a first guard 71A and a second guard 71B) and two cups 72 (a first cup 72A and a second cup 72B) are provided.

Each of the first cup 72A and the second cup 72B has an annular groove shape that is opened upward.

The first guard 71A is disposed such as to surround the spin base 21. The second guard 71B is disposed such as to surround the spin base 21 at further outer side in a rotational radius direction of a substrate W than the first guard 71A.

Each of the first guard 71A and the second guard 71B has a substantially circular cylindrical shape, and an upper end portion of each of the guards (the first guard 71A and the second guard 71B) is inclined inward such as to be directed toward the spin base 21.

The first cup 72A receives liquid guided downward by the first guard 71A. The second cup 72B is formed integral to the first guard 71A to receive liquid guided downward by the second guard 71B.

The processing unit 2 includes a guard elevating/lowering unit 74 that elevates and lowers each of the first guard 71A and the second guard 71B separately. The guard elevating/lowering unit 74 elevates and lowers the first guard 71A between the lower position and the upper position. The guard elevating/lowering unit 74 elevates and lowers the second guard 71B between a lower position and an upper position.

When the first guard 71A and the second guard 71B are both positioned at the upper position, liquid splashed from the substrate W is received by the first guard 71A. When the first guard 71A is positioned at the lower position and the second guard 71B is positioned at the upper position, liquid splashed from the substrate W is received by the second guard 71B.

The guard elevating/lowering unit 74 includes, for example, a first ball-screw mechanism (not shown) coupled to the first guard 71A, a first motor (not shown) that applies a driving force to the first ball screw mechanism, a second ball-screw mechanism (not shown) coupled to the second guard 71B, and a second motor (not shown) that applies a driving force to the second ball-screw mechanism. The guard elevating/lowering unit 74 is also referred to as a guard lifter.

The first moving nozzle 8 is an example of a chemical liquid supplying unit that supplies (discharges) a chemical liquid toward the upper surface of the substrate W held by the spin chuck 5.

The first moving nozzle 8 is moved in a horizontal direction and in a vertical direction by a first nozzle moving unit 36. The first moving nozzle 8 is capable of moving between a center position and a home position (retreat position) in the horizontal direction. When positioned at the center position, the first moving nozzle 8 faces a rotation center of the upper surface of the substrate W. The rotation center of the upper surface of the substrate W is a position of intersection of the rotational axis A1 with the upper surface of the substrate W. When positioned at the home position, the first moving nozzle 8 does not face the upper surface of the substrate W and is positioned outside the processing cup 7 in plan view. By moving in the vertical direction, the first moving nozzle 8 can move close to the upper surface of the substrate W and retreat upward from the upper surface of the substrate W.

The first nozzle moving unit 36 includes, for example, a pivoting shaft (not shown) oriented along the vertical direction, an arm (not shown) that is coupled to the pivoting shaft and extends horizontally, and a pivoting shaft driving unit (not shown) that elevates, lowers, and pivots the pivoting shaft.

The pivoting shaft driving unit pivots the pivoting shaft around a vertical pivoting axis, thereby swinging the arm. Further, the pivoting shaft driving unit elevates and lowers the pivoting shaft along the vertical direction, thereby moving the arm up and down. The first moving nozzle 8 is fixed to the arm. The first moving nozzle 8 moves in the horizontal direction and in the vertical direction in accordance with the swinging and elevation/lowering of the arm.

The first moving nozzle 8 is connected to a chemical liquid piping 40 that guides a chemical liquid. When a chemical liquid valve 50 interposed in the chemical liquid piping 40 is opened, the chemical liquid is discharged continuously downward from the first moving nozzle 8.

The chemical liquid discharged from the first moving nozzle 8 is, for example, a liquid that contains at least one of sulfuric acid, acetic acid, nitric acid, hydrochloric acid, hydrofluoric acid, ammonia water, hydrogen peroxide water, an organic acid (for example, citric acid, oxalic acid, etc.), an organic alkali (for example, TMAH: tetramethylammonium hydroxide, etc.), a surfactant, and a corrosion inhibitor. As examples of chemical liquids in which the above are mixed, SPM solution (sulfuric acid/hydrogen peroxide mixture), SC1 solution (ammonia-hydrogen peroxide mixture), etc., can be cited.

The second moving nozzle 9 is an example of a processing liquid supplying unit that supplies (discharges) a processing liquid toward the upper surface of the substrate W held by the spin chuck 5.

The second moving nozzle 9 is moved in a horizontal direction and in a vertical direction by a second nozzle moving unit 37. The second moving nozzle 9 is capable of moving between a center position and a home position (retreat position) in the horizontal direction. When positioned at the center position, the second moving nozzle 9 faces the rotation center of the upper surface of the substrate W. When positioned at the home position, the second moving nozzle 9 does not face the upper surface of the substrate W and is positioned outside the processing cup 7 in plan view. By moving in the vertical direction, the second moving nozzle 9 can move close to the upper surface of the substrate W and retreat upward from the upper surface of the substrate W.

The second nozzle moving unit 37 has the same configuration as the first nozzle moving unit 36. That is, the second nozzle moving unit 37 includes, for example, a pivoting shaft (not shown) oriented along the vertical direction, an arm (not shown) that is coupled to the pivoting shaft and the second moving nozzle 9 and extends horizontally, and a pivoting shaft driving unit (not shown) that elevates, lowers, and pivots the pivoting shaft.

The second moving nozzle 9 is connected to a processing liquid piping 41 that guides a processing liquid. When a processing liquid valve 51 interposed in the processing liquid piping 41 is opened, the processing liquid is discharged continuously downward from the second moving nozzle 9.

The processing liquid discharged from the second moving nozzle 9 contains a solute and a solvent. The processing liquid undergoes solidification or curing by at least a portion of the solvent volatilizing (evaporating). The processing liquid undergoes solidification or curing on the substrate W to form a processing film that holds an object to be removed, such as particles, etc., present on the substrate W.

Here, "solidification" refers, for example, to hardening of the solute due to forces acting between molecules or between atoms, etc., in association with the volatilization (evaporation) of the solvent. "Curing" refers, for example, to hardening of the solute due to a chemical change such as polymerization, crosslinking, etc. "Solidification or curing" thus expresses "hardening" of the solute due to any of various causes.

The third moving nozzle 10 is an example of a dissolving and peeling liquid forming liquid supplying unit (pure water supplying unit) that supplies (discharges) a dissolving and peeling liquid forming liquid, such as pure water, etc., toward the upper surface of the substrate W held by the spin chuck 5.

The third moving nozzle 10 is moved in a horizontal direction and in a vertical direction by a third nozzle moving unit 38. The third moving nozzle 10 is capable of moving between a center position and a home position (retreat position) in the horizontal direction. When positioned at the center position, the third moving nozzle 10 faces the rotation center of the upper surface of the substrate W. When positioned at the home position, the third moving nozzle 10 does not face the upper surface of the substrate W and is positioned outside the processing cup 7 in plan view. By moving in the vertical direction, the third moving nozzle 10 can move close to the upper surface of the substrate W and retreat upward from the upper surface of the substrate W.

The third nozzle moving unit 38 has the same configuration as the first nozzle moving unit 36. That is, the third nozzle moving unit 38 includes, for example, a pivoting shaft (not shown) oriented along the vertical direction, an arm (not shown) that is coupled to the pivoting shaft and the third moving nozzle 10 and extends horizontally, and a pivoting shaft driving unit (not shown) that elevates, lowers, and pivots the pivoting shaft.

The third moving nozzle 10 is connected to an upper dissolving and peeling liquid forming liquid piping 42 that guides a dissolving and peeling liquid forming liquid to the third moving nozzle 10. When an upper dissolving and peeling liquid forming liquid valve 52 interposed in the upper dissolving and peeling liquid forming liquid piping 42 is opened, the dissolving and peeling liquid forming liquid is discharged continuously downward from a discharge port of the third moving nozzle 10.

The dissolving and peeling liquid forming liquid is a liquid for forming a dissolving and peeling liquid to be described below. The dissolving and peeling liquid forming liquid is, for example, pure water, and DIW (deionized water) is especially preferable. A liquid besides DIW may be used instead as the dissolving and peeling liquid forming liquid. As a liquid besides DIW that is used as the dissolving and peeling liquid forming liquid, carbonated water, ammonia water of dilute concentration (for example, approximately 10 ppm ~ 100 ppm), etc., can be cited.

A low solubility substance, a high solubility substance, and a dissolving and peeling liquid forming substance are contained in the solute in the processing liquid discharged from the second moving nozzle 9.

The dissolving and peeling liquid forming substance is a substance that dissolves in the dissolving and peeling liquid forming liquid to form a dissolving and peeling liquid that peels the processing film from a surface of the substrate W. The dissolving and peeling liquid forming substance is, for example, a salt (alkaline component) that exhibits alkalinity (basicity) upon dissolving in the peeling liquid forming liquid. The dissolving and peeling liquid forming substance is, for example, a primary amine, a secondary amine, a tertiary amine, or a quaternary ammonium salt, etc. The dissolving and peeling liquid is an aqueous solution of a primary amine, a secondary amine, a tertiary amine, or a quaternary ammonium salt, etc., in other words, an alkaline aqueous solution (an alkaline liquid).

Substances mutually differing in solubilities in the dissolving and peeling liquid forming liquid and the dissolving and peeling liquid can be used as the low solubility substance and the high solubility substance. Specifically, as the high solubility substance, a substance that is higher in solubility in at least either of the dissolving and peeling liquid forming liquid and the dissolving and peeling liquid than the substance used as the low solubility substance can be used.

As long as it is higher in solubility in one of either of the dissolving and peeling liquid forming liquid and the dissolving and peeling liquid than the low solubility substance, the high solubility substance may be as low in solubility in the other of the dissolving and peeling liquid forming liquid and the peeling liquid as the low solubility substance and may be hardly soluble in the other of the dissolving and peeling liquid forming liquid and the dissolving and peeling liquid. Oppositely, even if a high solubility substance is higher in solubility in one of either of the dissolving and peeling liquid forming liquid and the dissolving and peeling liquid than the low solubility substance, it cannot be used if it is lower in solubility in the other of the dissolving and peeling liquid forming liquid and the dissolving and peeling liquid than the low solubility substance.

The low solubility substance contained in the processing liquid discharged from the second moving nozzle 9 is, for example, novolac, and the high solubility substance contained in the processing liquid discharged from the second moving nozzle 9 is, for example, 2,2-bis(4-hydroxyphenyl)propane.

The solvent contained in the processing liquid discharged from the second moving nozzle 9 suffices to be a liquid that dissolves the low solubility substance, the high solubility substance, and the dissolving and peeling liquid forming substance. The solvent contained in the processing liquid is preferably a liquid having compatibility (is miscible) with the dissolving and peeling liquid forming liquid. Details of the solvent, the low solubility substance, the high solubility substance, and the dissolving and peeling liquid forming substance contained in the processing liquid discharged from the second moving nozzle 9 shall be described below together with details of the dissolving and peeling liquid forming liquid discharged from the third moving nozzle 10.

The central nozzle 11 is housed in the internal space 60a of the hollow shaft 60 of the facing member 6. A discharge port 11a provided at a tip of the central nozzle 11 faces a central region of the upper surface of the substrate W from above. The central region of the upper surface of the substrate W is a region that includes the rotation center of the substrate W at the upper surface of the substrate W.

The central nozzle 11 includes a plurality of tubes (a first tube 31, a second tube 32 and a third tube 33) that each discharge a fluid downward and a cylindrical casing 30 that surrounds the plurality of tubes. The plurality of tubes and the casing 30 extend in an up/down direction along the rotational axis A1. The discharge port 11a of the central nozzle 11 also serves as a discharge port of the plurality of tubes.

The first tube 31 is an example of a rinse liquid supplying unit that supplies a rinse liquid to the upper surface of the substrate W. The second tube 32 is an example of a gas supplying unit that supplies a gas between the upper surface of the substrate W and the facing surface 6a of the facing member 6. The third tube 33 is an example of an organic solvent supplying unit that supplies an organic solvent, such as IPA, etc., to the upper surface of the substrate W.

The first tube 31 is connected to an upper rinse liquid piping 44 that guides the rinse liquid to the first tube 31. When an upper rinse liquid valve 54 interposed in the upper rinse liquid piping 44 is opened, the rinse liquid is discharged continuously toward the central region of the upper surface of the substrate W from the first tube 31 (central nozzle 11) .

The second tube 32 is connected to a gas piping 45 that guides the gas to the second tube 32. When a gas valve 55 interposed in the gas piping 45 is opened, the gas is discharged continuously downward from the second tube 32 (central nozzle 11).

The gas discharged from the second tube 32 is an inert gas, for example, nitrogen gas (N₂), etc. The gas discharged from the second tube 32 may be air. The inert gas is not restricted to nitrogen gas and is a gas that is inert with respect to the upper surface of the substrate W and a pattern formed on the upper surface of the substrate W. As examples of the inert gas other than nitrogen gas, noble gases, such as argon, etc., can be cited.

The third tube 33 is connected to an organic solvent piping 46 that guides the organic solvent to the third tube 33. When an organic solvent valve 56 interposed in the organic solvent piping 46 is opened, the organic solvent is discharged continuously toward the central region of the upper surface of the substrate W from the third tube 33 (central nozzle 11) .

The organic solvent discharged from the third tube 33 is a residue removing liquid for removing residue, that remains on the upper surface of the substrate W after removal of the processing film, by the dissolving and peeling liquid forming liquid.
The organic solvent discharged from the third tube 33 preferably has compatibility with the processing liquid and the rinse liquid.

As examples of the organic solvent discharged from the third tube 33, a liquid, etc., that contains at least one of IPA, HFE (hydrofluoroether), methanol, ethanol, acetone, and trans-1,2-dichloroethylene can be cited.

Also, the organic solvent discharged from the third tube 33 is not required to be constituted of just a single component but may be a liquid that is mixed with other components. The organic solvent discharged from the third tube 33 may, for example, be a liquid mixture of IPA and DIW or may be a liquid mixture of IPA and HFE.

The lower surface nozzle 12 is inserted into a penetrating hole 21a that is opened at an upper surface central portion of the spin base 21. A discharge port 12a of the lower surface nozzle 12 is exposed from an upper surface of the spin base 21. The discharge port 12a of the lower surface nozzle 12 faces a central region of a lower surface (surface at a lower side) of the substrate W from below. The central region of the lower surface of the substrate W is a region that includes the rotation center of the substrate W at the lower surface of the substrate W.

One end of a common piping 80 that guides the rinse liquid, the dissolving and peeling liquid forming liquid and the heating medium in common to the lower surface nozzle 12 is connected to the lower surface nozzle 12. A lower rinse liquid piping 81 that guides the rinse liquid to the common piping 80, a lower dissolving and peeling liquid forming liquid piping 82 that guides the dissolving and peeling liquid forming liquid to the common piping 80, and a heating medium piping 83 that guides the heating medium to the common piping 80 are connected to the other end of the common piping 80.

When a lower rinse liquid valve 86 interposed in the lower rinse liquid piping 81 is opened, the rinse liquid is discharged continuously toward the central region of the lower surface of the substrate W from the lower surface nozzle 12. When a lower dissolving and peeling liquid forming liquid valve 87 interposed in the lower dissolving and peeling liquid forming liquid piping 82 is opened, the dissolving and peeling liquid forming liquid is discharged continuously toward the central region of the lower surface of the substrate W from the lower surface nozzle 12. When a heating medium valve 88 interposed in the heating medium piping 83 is opened, the heating medium is discharged continuously toward the central region of the lower surface of the substrate W from the lower surface nozzle 12.

The lower surface nozzle 12 is an example of a lower rinse liquid supplying unit that supplies the rinse liquid to the lower surface of the substrate W. Also, the lower surface nozzle 12 is an example of a lower dissolving and peeling liquid forming liquid supplying unit that supplies the dissolving and peeling liquid forming liquid to the lower surface of the substrate W. Also, the lower surface nozzle 12 is an example of a heating medium supplying unit that supplies the heating medium for heating the substrate W to the substrate W. The lower surface nozzle 12 is also a substrate heating unit that heats the substrate W.

The heating medium discharged from the lower surface nozzle 12 is, for example, high temperature DIW, the temperature of which is higher than room temperature and lower than a boiling point of the solvent contained in the processing liquid. If the solvent contained in the processing liquid is IPA, for example, DIW of 60°C ~ 80°C is used. The heating medium discharged from the lower surface nozzle 12 is not restricted to the high temperature DIW and may be a high temperature gas, such as a high temperature inert gas or high temperature air, etc., the temperature of which is higher than room temperature and lower than the boiling point of the solvent contained in the processing liquid.

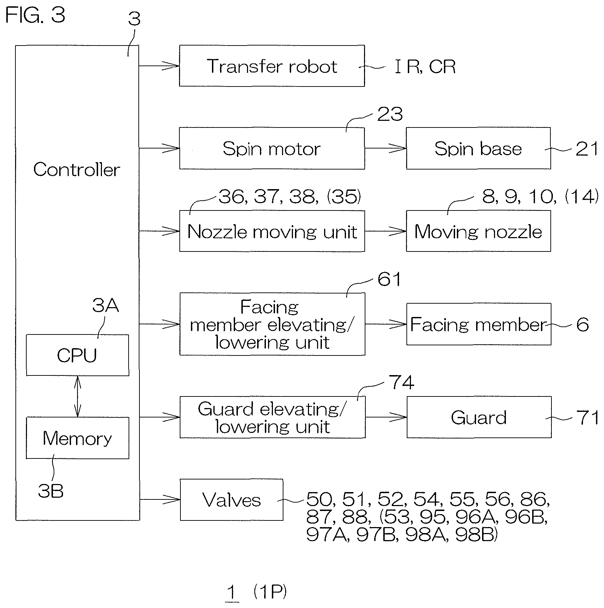

FIG. 3 is a block diagram of the electrical configuration of a main portion of the substrate processing apparatus 1. The controller 3 includes a microcomputer and controls control objects included in the substrate processing apparatus 1 in accordance with a predetermined control program.

Specifically, the controller 3 includes a processor (CPU) 3A and a memory 3B that stores control programs. The controller 3 is configured such that various types of control for substrate processing are executed by the processor 3A executing the control programs.

The controller 3 is programmed to control, in particular, the transfer robots IR and CR, the spin motor 23, the first nozzle moving unit 36, the second nozzle moving unit 37, the third nozzle moving unit 38, the facing member elevating/lowering unit 61, the guard elevating/lowering unit 74, the chemical liquid valve 50, the processing liquid valve 51, the upper dissolving and peeling liquid forming liquid valve 52, the upper rinse liquid valve 54, the gas valve 55, the organic solvent valve 56, the lower rinse liquid valve 86, the lower dissolving and peeling liquid forming liquid valve 87 and the heating medium valve 88.

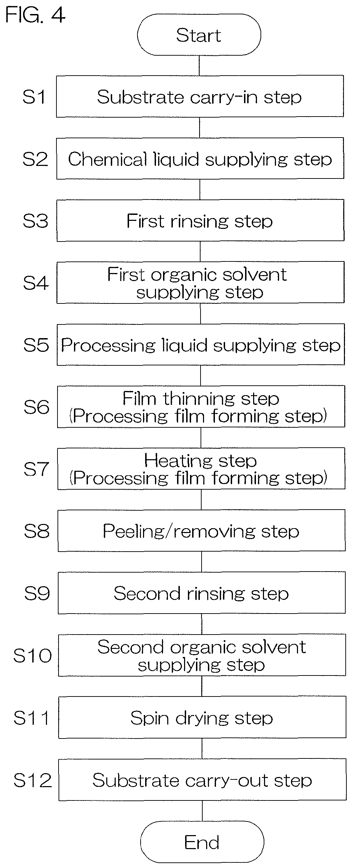

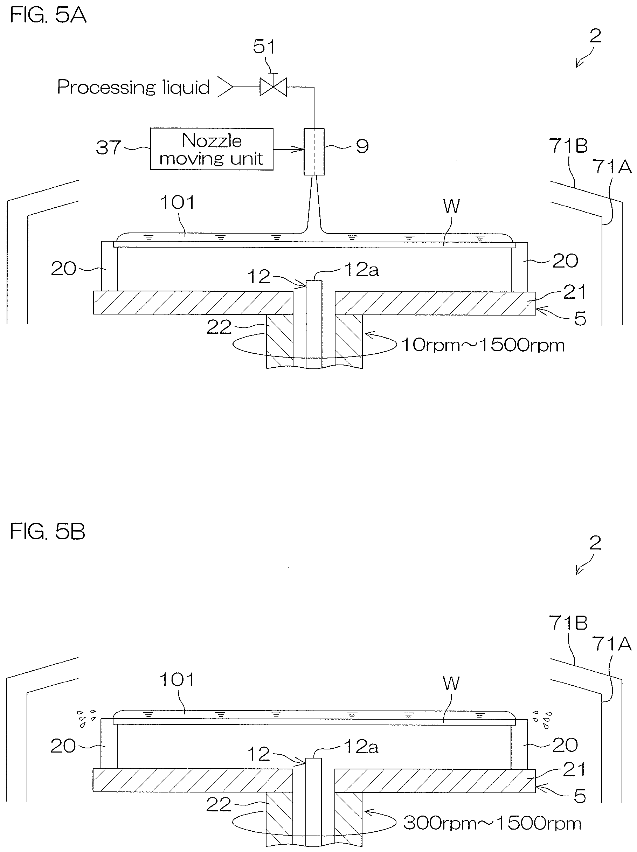

FIG. 4 is a flowchart for describing an example of substrate processing by the substrate processing apparatus 1. FIG. 4 mainly shows processing realized by execution of a program by the controller 3. FIG. 5A to FIG. 5G are schematic views for describing conditions of respective steps of the substrate processing.

In the substrate processing by the substrate processing apparatus 1, for example, as shown in FIG. 4, a substrate carry-in step (step S1), a chemical liquid supplying step (step S2), a first rinsing step (step S3), a first organic solvent supplying step (step S4), a processing liquid supplying step (step S5), a film thinning step (step S6), a heating step (step S7), a peeling/removing step (step S8), a second rinsing step (step S9), a second organic solvent supplying step (step S10), a spin drying step (step S11), and a substrate carry-out step (step S12) are executed in that order.

First, an unprocessed substrate W is carried from a carrier C into a processing unit 2 by the transfer robots IR and CR (see FIG. 1) and transferred to the spin chuck 5 (step S1). The substrate W is thereby held horizontally by the spin chuck 5 (substrate holding step). The holding of the substrate W by the spin chuck 5 is continued until the spin drying step (step S11) ends. When the substrate W is carried in, the facing member 6 is retreated at the upper position.

Next, after the transfer robot CR has retreated outside the processing unit 2, the chemical liquid supplying step (step S2) is started. Specifically, the spin motor 23 rotates the spin base 21. The horizontally held substrate W is thereby rotated (substrate rotating step). The guard elevating/lowering unit 74 then moves the first guard 71A and the second guard 71B to the upper positions.

The first nozzle moving unit 36 moves the first moving nozzle 8 to a processing position. The processing position of the first moving nozzle 8 is, for example, a central position. The chemical liquid valve 50 is then opened. The chemical liquid is thereby supplied (discharged) from the first moving nozzle 8 toward the central region of the upper surface of the substrate W in the rotating state. The chemical liquid supplied to the upper surface of the substrate W spreads radially by receiving a centrifugal force and spreads across the entire upper surface of the substrate W. The upper surface of the substrate W is thereby processed by the chemical liquid. The discharge of the chemical liquid from the first moving nozzle 8 is continued for a predetermined time of, for example, 30 seconds. In the chemical liquid supplying step, the substrate W is rotated at a predetermined chemical liquid rotational speed of, for example, 800 rpm.

Next, the first rinsing step (step S3) is started. In the first rinsing step, the chemical liquid on the substrate W is washed away with the rinse liquid.

Specifically, the chemical liquid valve 50 is closed. The supply of the chemical liquid to the substrate W is thereby stopped. The first nozzle moving unit 36 then moves the first moving nozzle 8 to the home position. The facing member elevating/lowering unit 61 then moves the facing member 6 to a processing position between the upper position and the lower position. When the facing member 6 is positioned at the processing position, a distance between the upper surface of the substrate W and the facing surface 6a is, for example, 30 mm. In the first rinsing step, the positions of the first guard 71A and the second guard 71B are kept at the upper positions.

The upper rinse liquid valve 54 is then opened. The rinse liquid is thereby supplied (discharged) from the central nozzle 11 toward the central region of the upper surface of the substrate W in the rotating state. The rinse liquid supplied to the upper surface of the substrate W from the central nozzle 11 spreads radially by receiving a centrifugal force and spreads across the entire upper surface of the substrate W. The chemical liquid on the upper surface of the substrate W is thereby washed away outside the substrate W. In the first rinsing step, the substrate W is rotated at a predetermined first rinsing rotational speed of, for example, 800 rpm.

Also, the lower rinse liquid valve 86 is opened. The rinse liquid is thereby supplied (discharged) from the lower surface nozzle 12 toward the central region of the lower surface of the substrate W in the rotating state. The rinse liquid supplied to the lower surface of the substrate W from the lower surface nozzle 12 spreads radially by receiving a centrifugal force and spreads across the entire lower surface of the substrate W. Even when the chemical liquid splashed from the substrate W by the chemical liquid supplying step is attached to the lower surface, the chemical liquid attached to the lower surface is washed away by the rinse liquid supplied from the lower surface nozzle 12. The discharges of the rinse liquid from the central nozzle 11 and the lower surface nozzle 12 are continued for a predetermined time of, for example, 30 seconds.

Next, the first organic solvent supplying step (step S4) is started. In the first organic solvent supplying step, the rinse liquid on the substrate W is replaced with the organic solvent.

Specifically, the upper rinse liquid valve 54 and the lower rinse liquid valve 86 are closed. The supplies of the rinse liquid to the upper surface and the lower surface of the substrate W are thereby stopped. The guard elevating/lowering unit 74 then moves the first guard 71A to the lower position in a state of keeping the second guard 71B at the upper position. The facing member 6 is kept at the processing position.

The organic solvent valve 56 is then opened. The organic solvent is thereby supplied (discharged) from the central nozzle 11 toward the central region of the upper surface of the substrate W in the rotating state.

The organic solvent supplied from the central nozzle 11 to the upper surface of the substrate W spreads radially by receiving a centrifugal force and spreads across the entire upper surface of the substrate W. The rinse liquid on the substrate W is thereby replaced with the organic solvent. The discharge of the organic solvent from the central nozzle 11 is continued for a predetermined time of, for example, 10 seconds.

In the first organic solvent supplying step, the substrate W is rotated at a predetermined first organic solvent rotational speed of, for example, 300 rpm ~ 1500 rpm. It is not necessary to rotate the substrate W at a fixed rotational speed in the first organic solvent supplying step. For example, the spin motor 23 may rotate the substrate W at 300 rpm at the start of supplying the organic solvent and may accelerate the rotation of the substrate W until the rotational speed of the substrate W reaches 1500 rpm while the organic solvent is being supplied to the substrate W.

Next, the processing liquid supplying step (step S5) is started. Specifically, the organic solvent valve 56 is closed. The supply of the organic solvent to the substrate W is thereby stopped. The facing member elevating/lowering unit 61 then moves the facing member 6 to the upper position. The guard elevating/lowering unit 74 moves the first guard 71A to the upper position. In the processing liquid supplying step, the substrate W is rotated at a predetermined processing liquid rotational speed of, for example, 10 rpm ~ 1500 rpm.

Then, as shown in FIG. 5A, the second nozzle moving unit 37 moves the second moving nozzle 9 to a processing position. The processing position of the second moving nozzle 9 is, for example, the central position. The processing liquid valve 51 is then opened. The processing liquid is thereby supplied (discharged) from the second moving nozzle 9 toward the central region of the upper surface of the substrate W in the rotating state (processing liquid supplying step, processing liquid discharging step). The organic solvent on the substrate W is thereby replaced with the processing liquid, and a liquid film 101 of the processing liquid (processing liquid film) is formed on the substrate W (processing liquid film forming step). The supply of the processing liquid from the second moving nozzle 9 is continued for a predetermined time of, for example, 2 seconds ~ 4 seconds.

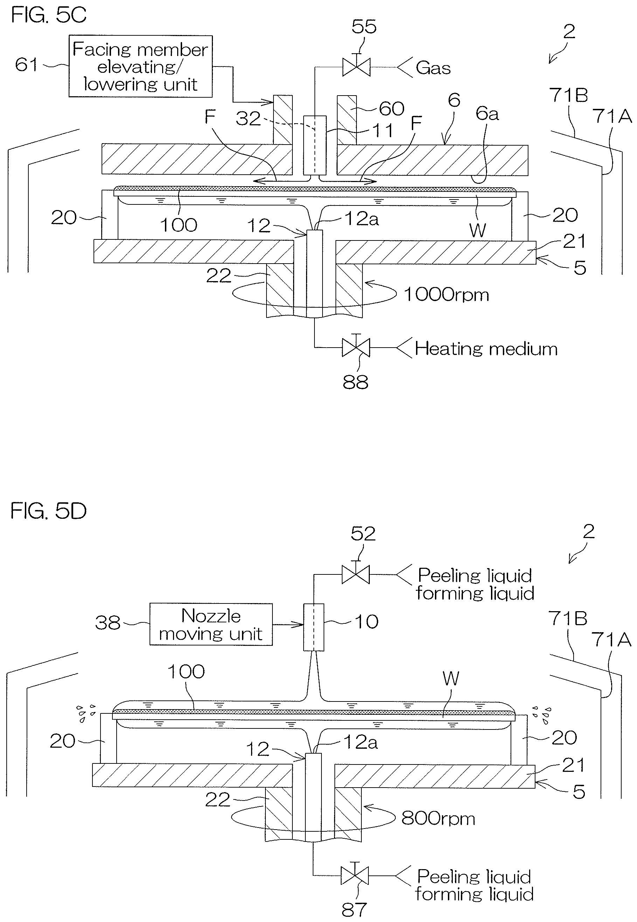

Next, the processing film forming step (step S6 and step S7) is executed. In the processing film forming step, the processing liquid on the substrate W is solidified or cured to form, on the upper surface of the substrate W, a processing film 100 that holds an object to be removed present on the substrate W (see FIG. 5C).

In the processing film forming step, the film thinning step (spin off step) (step S6) is executed. In the film thinning step, first, the processing liquid valve 51 is closed. The supply of the processing liquid to the substrate W is thereby stopped. The second moving nozzle 9 is then moved to the home position by the second nozzle moving unit 37.

As shown in FIG. 5B, in the film thinning step, a portion of the processing liquid is eliminated from the upper surface of the substrate W by the centrifugal force in a state where the supply of the processing liquid to the upper surface of the substrate W is stopped such that a thickness of the liquid film 101 on the substrate W becomes an appropriate thickness. In the film thinning step, the facing member 6, the first guard 71A, and the second guard 71B are kept at the upper positions.

In the film thinning step, the spin motor 23 changes the rotational speed of the substrate W to a predetermined film thinning speed. The film thinning speed is, for example, 300 rpm ~ 1500 rpm. The rotational speed of the substrate W may be kept fixed within a range of 300 rpm ~ 1500 rpm or may be changed whenever necessary within the range of 300 rpm ~ 1500 rpm in the middle of the film thinning step. The film thinning step is executed for a predetermined time of, for example, 30 seconds.

In the processing film forming step, the heating step (step S7) of heating the substrate W is executed after the film thinning step. In the heating step, the liquid film 101 (see FIG. 5B) on the substrate W is heated to volatilize (evaporate) a portion of the solvent of the processing liquid on the substrate W.

Specifically, as shown in FIG. 5C, the facing member elevating/lowering unit 61 moves the facing member 6 to a proximity position between the upper position and the lower position. The proximity position may be the lower position. The proximity position is a position where a distance from the upper surface of the substrate W to the facing surface 6a is, for example, 1 mm. In the heating step, the first guard 71A and the second guard 71B are kept at the upper positions.

The gas valve 55 is then opened. The gas is thereby supplied to the space between the upper surface of the substrate W (an upper surface of the liquid film 101) and the facing surface 6a of the facing member 6 (gas supplying step).

The evaporation (volatilization) of the solvent in the liquid film 101 is promoted by the gas being blown onto the liquid film 101 on the substrate W (solvent evaporating step, solvent evaporation promoting step). A time required to form the processing film 100 can thus be reduced. The central nozzle 11 functions as an evaporating unit (evaporation promoting unit) for evaporating the solvent in the processing liquid.

Also, the heating medium valve 88 is opened. The heating medium is thereby supplied (discharged) from the lower surface nozzle 12 toward the central region of the lower surface of the substrate W in the rotating state (heating medium supplying step, heating medium discharging step). The heating medium supplied from the lower surface nozzle 12 to the lower surface of the substrate W spreads radially by receiving a centrifugal force and spreads across the entire lower surface of the substrate W. The supply of the heating medium to the substrate W is continued for a predetermined time of, for example, 60 seconds. In the heating step, the substrate W is rotated at a predetermined heating rotational speed of, for example, 1000 rpm.

By the heating medium being supplied to the lower surface of the substrate W, the liquid film 101 on the substrate W is heated via the substrate W. The evaporation (volatilization) of the solvent in the liquid film 101 is thereby promoted (solvent evaporating step, solvent evaporation promoting step). A time required to form the processing film 100 can thus be reduced. The lower surface nozzle 12 functions as an evaporating unit (evaporation promoting unit) for evaporating the solvent in the processing liquid.

By the film thinning step and the heating step being executed, the processing liquid is solidified or cured to form the processing film 100 on the substrate W. The substrate rotating unit (the spin motor 23), the central nozzle 11, and the lower surface nozzle 12 thus constitute a solid forming unit that solidifies or cures the processing liquid to form a solid (the processing film 100).

In the heating step, it is preferable for the substrate W to be heated such that a temperature of the processing liquid on the substrate W is lower than the boiling point of the solvent. By the processing liquid being heated to the temperature lower than the boiling point of the solvent, the solvent can be made to remain appropriately in the processing film 100. The dissolving and peeling liquid forming liquid is thereby readily compatibilized with the processing film 100 in the subsequent peeling/removing step by interaction of the solvent remaining inside the processing film 100 and the dissolving and peeling liquid forming liquid in comparison to a case where the solvent does not remain within the processing film 100. The dissolving and peeling liquid can thus be formed readily.

The heating medium that splashed outside the substrate W due to the centrifugal force is received by the first guard 71A. The heating medium received by the first guard 71A may splash back from the first guard 71A. However, since the facing member 6 is kept close to the upper surface of the substrate W, the upper surface of the substrate W can be protected from the heating medium that splashed back from the first guard 71A. Therefore, attachment of the heating medium to an upper surface of the processing film 100 can be suppressed, and forming of particles due to the splashing back of the heating medium from the first guard 71A can thus be suppressed.

Further, by the supply of the gas from the central nozzle 11, a gas stream F that moves from the central region of the upper surface of the substrate W toward a peripheral edge of the upper surface of the substrate W is formed in the space between the facing surface 6a of the facing member 6 and the upper surface of the substrate W. By forming the gas stream F that moves from the central region of the upper surface of the substrate W toward the peripheral edge of the upper surface of the substrate W, the heating medium splashed back from the first guard 71A can be pushed back toward the first guard 71A. The attachment of the heating medium to the upper surface of the processing film 100 can thus be suppressed further.

Next, the peeling/removing step (step S8) of peeling and removing the processing film 100 from the upper surface of the substrate W is executed. Specifically, the heating medium valve 88 is closed. The supply of the heating medium to the lower surface of the substrate W is thereby stopped. Also, the gas valve 55 is closed. The supply of the gas to the space between the facing surface 6a of the facing member 6 and the upper surface of the substrate W is thereby stopped.

The facing member elevating/lowering unit 61 then moves the facing member 6 to the upper position. Then, as shown in FIG. 5D, the third nozzle moving unit 38 moves the third moving nozzle 10 to a processing position. The processing position of the third moving nozzle 10 is, for example, the central position.

The upper dissolving and peeling liquid forming liquid valve 52 is then opened. The dissolving and peeling liquid forming liquid is thereby supplied (discharged) from the third moving nozzle 10 toward the central region of the upper surface of the substrate W in the rotating state (upper dissolving and peeling liquid forming liquid supplying step, upper dissolving and peeling liquid forming liquid discharging step). The peeling liquid forming liquid supplied to the upper surface of the substrate W spreads across the entire upper surface of the substrate W due to a centrifugal force.

The supply of the dissolving and peeling liquid forming liquid to the upper surface of the substrate W is continued for a predetermined time of, for example, 60 seconds. As mentioned above, the supply time of the processing liquid to the upper surface of the substrate W in the processing liquid supplying step is, for example, 2 ~ 4 seconds. The supply time of the dissolving and peeling liquid forming liquid to the upper surface of the substrate W in the peeling/removing step is thus longer than the supply time of the processing liquid to the upper surface of the substrate W in the processing liquid supplying step.

In the peeling/removing step, the substrate W is rotated at a predetermined peeling rotational speed of, for example, 800 rpm.

Also, the lower dissolving and peeling liquid forming liquid valve 87 is opened. The dissolving and peeling liquid forming liquid is thereby supplied (discharged) from the lower surface nozzle 12 toward the central region of the lower surface of the substrate W in the rotating state (lower dissolving and peeling liquid forming liquid supplying step, lower dissolving and peeling liquid forming liquid discharging step). The dissolving and peeling liquid forming liquid supplied to the lower surface of the substrate W spreads across the entire lower surface of the substrate W due to a centrifugal force.

By the dissolving and peeling liquid forming liquid being supplied to the upper surface of the substrate W, the dissolving and peeling liquid forming liquid and the processing film 100 are put in contact and the dissolving and peeling liquid is formed. The processing film 100 is then peeled together with the object to be removed from the upper surface of the substrate W by a peeling action of the dissolving and peeling liquid (dissolving and peeling step). In being peeled from the upper surface of the substrate W, the processing film 100 splits into film fragments. Then, after the peeling of the processing film 100, the film fragments of the split processing film 100 are eliminated outside the substrate W together with the peeling liquid forming liquid by the supply of the peeling liquid forming liquid to the upper surface of the substrate W being continued. The film fragments of the processing film 100 in the state of holding the object to be removed are thereby removed from the upper surface of the substrate W (removing step).

Here, the processing liquid supplied to the upper surface of the substrate W in the processing liquid supplying step (step S5) shown in FIG. 5A may flow along the peripheral edge of the substrate W and flow around to the lower surface of the substrate W. Also, the processing liquid that splashed from the substrate W may splash back from the first guard 71A and become attached to the lower surface of the substrate W. Even in these cases, the heating medium is supplied to the lower surface of the substrate W in the heating step (step S7) as shown in FIG. 5C, and the processing liquid can thus be eliminated from the lower surface of the substrate W by a flow of the heating medium.

Further, the processing liquid that became attached to the lower surface of the substrate W due to the processing liquid supplying step (step S5) may become solidified or cured and form a solid. Even in such a case, the solid can be peeled and removed from the lower surface of the substrate W by the dissolving and peeling liquid forming liquid being supplied (discharged) from the lower surface nozzle 12 to the lower surface of the substrate W while the dissolving and peeling liquid forming liquid is supplied to the upper surface of the substrate W in the peeling/removing step (step S8) as shown in FIG. 5D. In detail, the dissolving and peeling liquid is formed by the contact of the dissolving and peeling liquid forming liquid and the solid, and the solid is peeled from the lower surface of the substrate W by the peeling action of the dissolving and peeling liquid.

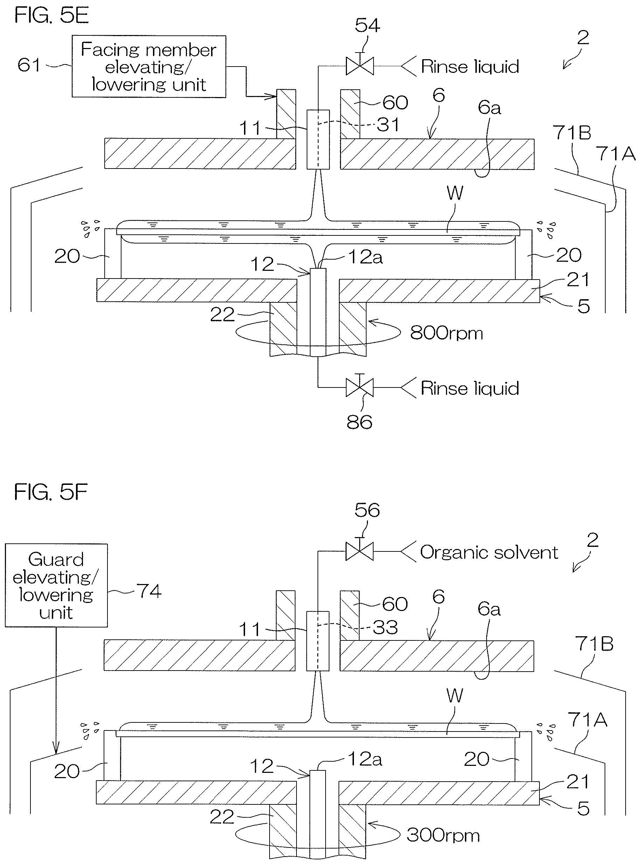

After the peeling/removing step (step S8), the second rinsing step (step S9) is executed. Specifically, the upper dissolving and peeling liquid forming liquid valve 52 and the lower dissolving and peeling liquid forming liquid valve 87 are closed. The supplies of the dissolving and peeling liquid forming liquid to the upper surface and the lower surface of the substrate W are thereby stopped. The third nozzle moving unit 38 then moves the third moving nozzle 10 to the home position. Then, as shown in FIG. 5E, the facing member elevating/lowering unit 61 moves the facing member 6 to the processing position. In the second rinsing step, the substrate W is rotated at a predetermined second rinsing rotational speed of, for example, 800 rpm. The first guard 71A and the second guard 71B are kept at the upper positions.

The upper rinse liquid valve 54 is then opened. The rinse liquid is thereby supplied (discharged) from the central nozzle 11 toward the central region of the upper surface of the substrate W in the rotating state (second upper rinse liquid supplying step, second upper rinse liquid discharging step). The rinse liquid supplied to the upper surface of the substrate W spreads across the entire upper surface of the substrate W due to a centrifugal force. The dissolving and peeling liquid forming liquid attached to the upper surface of the substrate W is thereby washed away with the rinse liquid.

Also, the lower rinse liquid valve 86 is opened. The rinse liquid is thereby supplied (discharged) from the lower surface nozzle 12 toward the central region of the lower surface of the substrate W in the rotating state (second lower rinse liquid supplying step, second lower rinse liquid discharging step). The dissolving and peeling liquid forming liquid attached to the lower surface of the substrate W is thereby washed away with the rinse liquid. The supplies of the rinse liquid to the upper surface and the lower surface of the substrate W are continued for a predetermined time of, for example, 35 seconds.

Next, the second organic solvent supplying step (step S10) is executed. Specifically, the upper rinse liquid valve 54 and the lower rinse liquid valve 86 are closed. The supplies of the rinse liquid to the upper surface and the lower surface of the substrate W are thereby stopped. Then, as shown in FIG. 5F, the guard elevating/lowering unit 74 moves the first guard 71A to the lower position. The facing member 6 is then kept at the processing position. In the second organic solvent supplying step, the substrate W is rotated at a predetermined second organic solvent rotational speed of, for example, 300 rpm.

The organic solvent valve 56 is then opened. The organic solvent is thereby supplied (discharged) from the central nozzle 11 toward the central region of the upper surface of the substrate W in the rotating state (second organic solvent supplying step, second organic solvent discharging step, residue removing liquid supplying step). The supply of the organic solvent to the upper surface of the substrate W is continued for a predetermined time of, for example, 30 seconds.

The organic solvent supplied to the upper surface of the substrate W spreads radially by receiving a centrifugal force and spreads across the entire upper surface of the substrate W. The rinse liquid on the upper surface of the substrate W is thereby replaced with the organic solvent. The organic solvent supplied to the upper surface of the substrate W dissolves residue of the processing film 100 remaining on the upper surface of the substrate W and is thereafter expelled from the peripheral edge of the upper surface of the substrate W (residue removing step).

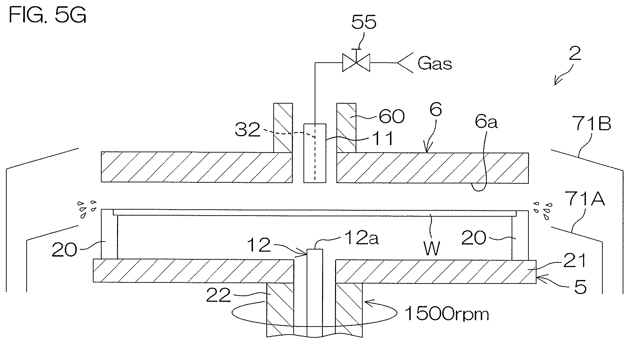

Next, the spin drying step (step S11) is executed. Specifically, the organic solvent valve 56 is closed. The supply of the organic solvent to the upper surface of the substrate W is thereby stopped. Then, as shown in FIG. 5G, the facing member elevating/lowering unit 61 moves the facing member 6 to a drying position lower than the processing position. When the facing member 6 is positioned at the drying position, the distance between the facing surface 6a of the facing member 6 and the upper surface of the substrate W is, for example, 1.5 mm. The gas valve 55 is then opened. The gas is thereby supplied to the space between the upper surface of the substrate W and the facing surface 6a of the facing member 6.

The spin motor 23 then accelerates the rotation of the substrate W to rotate the substrate W at a high speed. The substrate W is rotated at a drying speed of, for example, 1500 rpm in the spin drying step. The spin drying step is executed for a predetermined time of, for example, 30 seconds. Thereby, a large centrifugal force acts on the organic solvent on the substrate W and the organic solvent on the substrate W is spun off to a periphery of the substrate W. In the spin drying step, the evaporation of the organic solvent is promoted by the supply of the gas to the space between the upper surface of the substrate W and the facing surface 6a of the facing member 6.

The spin motor 23 then stops the rotation of the substrate W. The guard elevating/lowering unit 74 moves the first guard 71A and the second guard 71B to the lower positions. The gas valve 55 is closed. The facing member elevating/lowering unit 61 then moves the facing member 6 to the upper position.

The transfer robot CR enters into the processing unit 2, lifts up the processed substrate W from the chuck pin 20 of the spin chuck 5 and carries it outside the processing unit 2 (step S12). The substrate W is transferred from the transfer robot CR to the transfer robot IR and housed in a carrier C by the transfer robot IR.

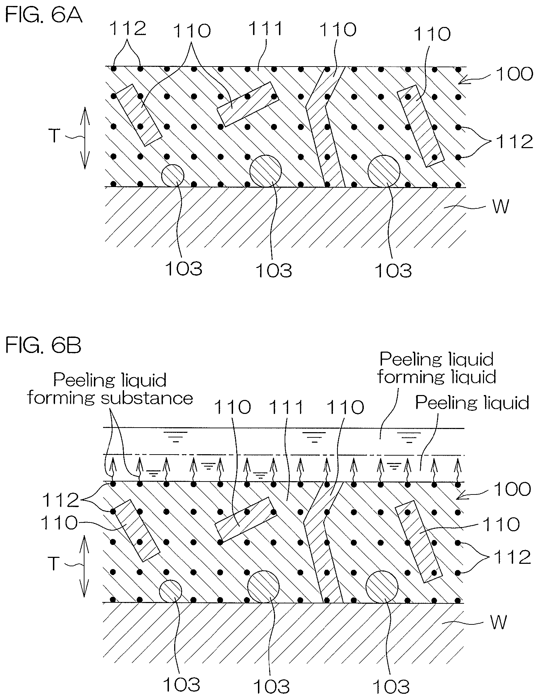

Next, conditions in which the processing film 100 is peeled from the substrate W shall be described with reference to FIG. 6A to FIG. 6D. FIG. 6A shows conditions in a vicinity of the upper surface of the substrate W after the heating step (step S7). FIG. 6B to FIG. 6D show conditions in the vicinity of the upper surface of the substrate W during execution of the peeling/removing step (step S8).

As described above, in the heating step executed in the processing film forming step, the liquid film 101 on a substrate W is heated by the heating medium via the substrate W. The processing film 100 that holds removal objects 103, such as particles, etc., is thereby formed as shown in FIG. 6A. In detail, by at least a portion of the solvent evaporating, the high solubility substance contained in the solute of the processing liquid forms high solubility solids 110 (the high solubility substance in a solid state). Also, by at least a portion of the solvent evaporating, the low solubility substance contained in the solute of the processing liquid forms a low solubility solid 111 (the low solubility substance in a solid state), and the dissolving and peeling liquid forming substance contained in the solute of the processing liquid forms a dissolving and peeling liquid forming solids 112 (the dissolving and peeling liquid forming substance in a solid state).

The processing film 100 is divided into portions in which the high solubility solids 110 are biasedly present and portions in which the low solubility solid 111 is biasedly present. The dissolving and peeling liquid forming solids 112 are formed uniformly across the entire processing film 100.

Referring to FIG. 6B, when, the dissolving and peeling liquid forming liquid is supplied to the upper surface of the substrate W in the peeling/removing step, the dissolving and peeling liquid forming solids 112 become eluted into the dissolving and peeling liquid formingliquid. By the dissolving and peeling liquid forming solids 112 dissolving in the dissolving and peeling liquid forming liquid, the dissolving and peeling liquid, i.e. the alkaline liquid, is formed.

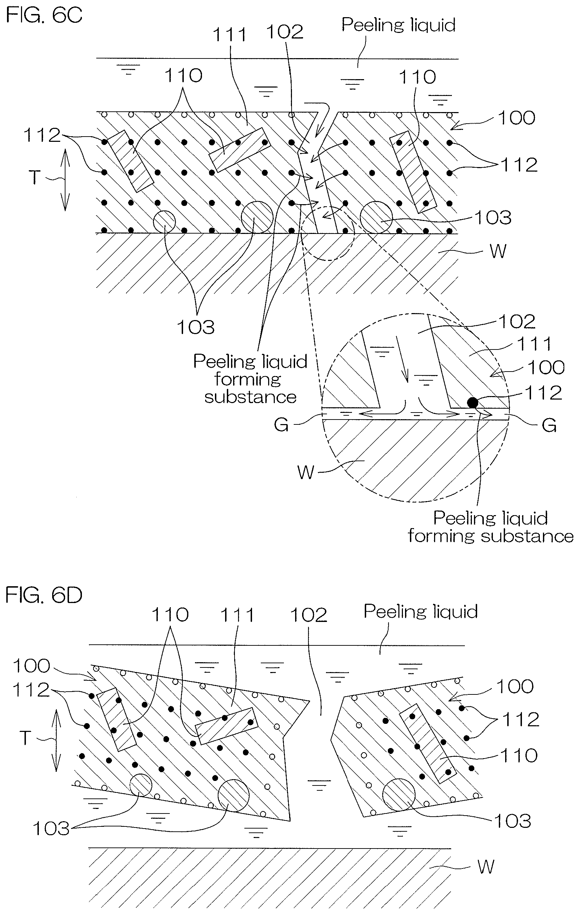

Referring to FIG. 6C, due to the supply of the dissolving and peeling liquid forming liquid, the high solubility solids 110 become dissolved. That is, the processing film 100 becomes partially dissolved. By the dissolution of the high solubility solids 110, penetrating holes 102 are formed in the portions of the processing film 100 at which the high solubility solids 110 are biasedly present (penetrating hole forming step) . The penetrating holes 102 are likely to be formed in particular in portions in which the high solubility solids 110 extend in a thickness direction T of the substrate W (that is also a thickness direction of the processing film 100). Each penetrating hole 102 has a size of, for example, several nm in diameter in plan view.

If the high solubility solids 110 have a property of dissolving in both the dissolving and peeling liquid forming liquid and the dissolving and peeling liquid, the penetrating holes 102 begin to be formed at the instant the dissolving and peeling liquid forming liquid lands on the processing film 100, even if the dissolving and peeling liquid forming substance is not sufficiently eluted into the dissolving and peeling liquid forming liquid. When the dissolving and peeling liquid is then formed, the forming of the penetrating holes 102 is promoted. That is, the penetrating holes 102 are formed by both the dissolving and peeling liquid and the dissolving and peeling liquid forming liquid.

If the high solubility solids 110 have a property of hardly dissolving in the dissolving and peeling liquid forming liquid but dissolves in the dissolving and peeling liquid, the penetrating holes 102 begin to be formed after the dissolving and peeling liquid forming substance becomes sufficiently eluted into the dissolving and peeling liquid forming liquid. That is, the penetrating holes 102 are formed by the dissolving and peeling liquid.

If the high solubility solids 110 have a property of hardly dissolving in the dissolving and peeling liquid but dissolves in the dissolving and peeling liquid forming liquid, the penetrating holes 102 are formed before the dissolving and peeling liquid forming substance becomes eluted into the dissolving and peeling liquid forming liquid. That is, the penetrating holes 102 are formed by the dissolving and peeling liquid forming liquid.

By the time the penetrating holes 102 are formed, the dissolving and peeling liquid forming substance will have become eluted from the processing film 100 into the dissolving and peeling liquid forming liquid and the dissolving and peeling liquid will have been formed. The solubility of the low solubility substance in the dissolving and peeling liquid is low and the low solubility substance is hardly dissolved in the dissolving and peeling liquid. The low solubility solid 111 is thus dissolved only slightly at a vicinity of a surface thereof by the dissolving and peeling liquid. The dissolving and peeling liquid reaching to the vicinity of the upper surface of the substrate W via the penetrating hole 102 thus slightly dissolves a portion of the low solubility solid 111 in the vicinity of the upper surface of the substrate W. Thereby, as shown in an enlarged view in FIG. 6C, the dissolving and peeling liquid, while gradually dissolving the low solubility solid 111 in the vicinity of the upper surface of the substrate W, enters gaps G between the processing film 100 and the upper surface of the substrate W (dissolving and peeling liquid entry step) .

When locations of the processing film 100 at which the high solubility solids 110 are biasedly present are being dissolved, the dissolving and peeling liquid forming solids 112 present at those locations and the dissolving and peeling liquid forming solids 112 present at portions of the processing film 100 surrounding the penetrating holes 102 become dissolved by the dissolving and peeling liquid (dissolving and peeling liquid forming liquid). Similarly, by the dissolving and peeling liquid entering the gaps G, the dissolving and peeling liquid forming solids 112 present at the portions of the processing film 100 in the vicinity of the upper surface of the substrate W become dissolved by the dissolving and peeling liquid. A concentration of the alkaline component in the dissolving and peeling liquid is thereby increased further (see the enlarged view in FIG. 6C). Peeling of the low solubility solid 111 of the processing film 100 is thus promoted further.

Then, for example, with peripheral edges of the penetrating holes 102 as starting points, the processing film 100 becomes split into film fragments, and as shown in FIG. 6D, the film fragments of the processing film 100 become peeled from the substrate W in a state of holding the objects to be removed 103 (processing film splitting step, peeling step). By then continuing the supply of the dissolving and peeling liquid forming liquid, the processing film 100 that has become film fragments is washed away (pushed outside the substrate W) and removed, in the state of holding the objects to be removed 103, from the upper surface of the substrate W (removing step).

There may be a case where the dissolving and peeling liquid hardly dissolves the low solubility solid 111. Even in this case, by entry into the slight gaps G between the processing film 100 and the upper surface of the substrate W, the processing film 100 is peeled from the substrate W.

According to the invention, by putting the dissolving and peeling liquid forming liquid (pure water), supplied to the upper surface of the substrate W, and the processing film 100 in contact, the dissolving and peeling liquid (the alkaline liquid) that peels the processing film 100 from the upper surface of the substrate W is formed. Specifically, the alkaline component inside the processing film 100 becomes eluted into the pure water and the alkaline liquid (the alkaline aqueous solution) is formed. The dissolving and peeling liquid forming liquid is comparatively inexpensive, and among liquids used as the dissolving and peeling liquid forming liquid, pure water is especially inexpensive. The alkaline liquid used as the dissolving and peeling liquid is comparatively expensive.

By the dissolving and peeling liquid that is formed spontaneously on the substrate W, the processing film 100 in the state of holding the objects to be removed 103 is peeled from the upper surface of the substrate W. By then continuing the supply of the dissolving and peeling liquid forming liquid, the processing film 100 can be washed away and removed from the upper surface of the substrate W in the state where the objects to be removed 103 are held by the processing film 100. That is, the objects to be removed 103 can be removed from the upper surface of the substrate W by just supplying the dissolving and peeling liquid forming liquid without supplying the dissolving and peeling liquid toward the upper surface of the substrate W. That is, the objects to be removed 103 can be removed from the upper surface of the substrate W without consuming the comparatively expensive dissolving and peeling liquid in a large amount. The objects to be removed 103 present on the upper surface of the substrate W can thus be removed efficiently while suppressing cost increase.

Also, according to the present invention, the dissolving and peeling liquid is formed by dissolving the dissolving and peeling liquid forming solids 112 inside the processing film 100 in the dissolving and peeling liquid forming liquid. The dissolving and peeling liquid can thus be formed in a vicinity of the processing film 100 by dissolving the dissolving and peeling liquid forming substance in the dissolving and peeling liquid forming liquid in the vicinity of the processing film 100. The dissolving and peeling liquid that is high in concentration of the dissolving and peeling liquid forming substance before the dissolving and peeling liquid forming substance diffuses uniformly throughout the entire dissolving and peeling liquid forming liquid can thus be made to act on the processing film 100. The processing film 100 can thereby be peeled efficiently. The objects to be removed 103 are thus removed efficiently together with the processing film 100 from the upper surface of the substrate W.

As with the dissolving and peeling liquid, the dissolving and peeling liquid forming substance required for forming the dissolving and peeling liquid is also comparatively expensive. Also, a time required to supply an amount of the processing liquid required to form the processing film 100 to the substrate W (for example, 2 seconds ~ 4 seconds) is shorter than a time required for peeling and removing the processing film 100 from the substrate (for example, 60 seconds). Thus, in the present preferred embodiment, the processing liquid that contains the dissolving and peeling liquid forming substance is supplied to the substrate W for forming the processing film 100 and the dissolving and peeling liquid forming liquid that does not contain the dissolving and peeling liquid forming substance is supplied to the substrate W for peeling and removing the processing film 100. The supply time (consumption amount) of the dissolving and peeling liquid forming substance to the substrate W can thus be reduced in comparison to a method where a processing liquid that does not contain the dissolving and peeling liquid forming substance is supplied to the substrate W for forming the processing film 100 and the dissolving and peeling liquid (the dissolving and peeling liquid forming liquid with the dissolving and peeling liquid forming substance dissolved therein) is supplied to the substrate for peeling and removing the processing film 100. Cost increase can thus be suppressed.

When the dissolving and peeling liquid, such as the alkaline liquid, etc., is supplied in a large amount toward the upper surface of the substrate W, it may damage the substrate W and respective components of the substrate processing apparatus 1. The substrate W and components having peeling liquid resistance performance (alkaline resistance performance) must thus be used and cost may thus increase.

In the present invention, the dissolving and peeling liquid can be formed spontaneously by the contact of the pure water, carbonated water, or ammonia water of dilute concentration, that hardly damages the upper surface of the substrate W and the processing film 100. The objects to be removed 103 can thus be removed from the upper surface of the substrate W by just supplying the dissolving and peeling liquid forming liquid without supplying the dissolving and peeling liquid toward the upper surface of the substrate W. That is, the objects to be removed 103 can be removed from the upper surface of the substrate W without supplying a large amount of a dissolving and peeling liquid that readily damages the substrate W and the respective components of the substrate processing apparatus 1 to the substrate W. Damage to the substrate W and the respective components of the substrate processing apparatus 1 can thus be suppressed. Further, there is also no need to improve the dissolving and peeling liquid resistance performances of the substrate W and the respective components of the substrate processing apparatus 1 and cost increase can thus be suppressed.

Also, in the present invention, by supplying the dissolving and peeling liquid forming liquid to the upper surface of the substrate W, the processing film 100 is partially dissolved to form the penetrating holes 102 in the processing film 100. By the penetrating holes 102 being formed in the processing film 100, the dissolving and peeling liquid is enabled to readily reach the vicinity of the upper surface of the substrate W. Therefore, the dissolving and peeling liquid can be made to act on an interface between the processing film 100 and the substrate W to enable the processing film 100 to be peeled efficiently from the upper surface of the substrate W. On the other hand, although the processing film 100 is partially dissolved for forming the penetrating holes 102, a remaining portion thereof is kept in a solid state, that is, in the state of holding the removal objects 103. Consequently, the objects to be removed 103 can be removed efficiently together with the processing film 100 from the upper surface of the substrate W.

According to the present invention, the high solubility substance is higher in solubility in at least either of the dissolving and peeling liquid forming liquid and the dissolving and peeling liquid than the low solubility substance. The penetrating holes 102 can thus be formed reliably in the processing film 100 by the dissolving and peeling liquid forming liquid or the dissolving and peeling liquid dissolving the high solubility solids 110 inside the processing film 100. On the other hand, the low solubility solid 111 inside the processing film 100 is kept in the solid state without being dissolved. Therefore, the dissolving and peeling liquid can be made to act on an interface between the low solubility solid 111 in the solid state and the substrate W while the objects to be removed 103 are held by the low solubility solid 111. Consequently, the processing film 100 can be peeled quickly from the upper surface of the substrate W and meanwhile the objects to be removed 103 can be removed efficiently together with the processing film 100 from the upper surface of the substrate W.

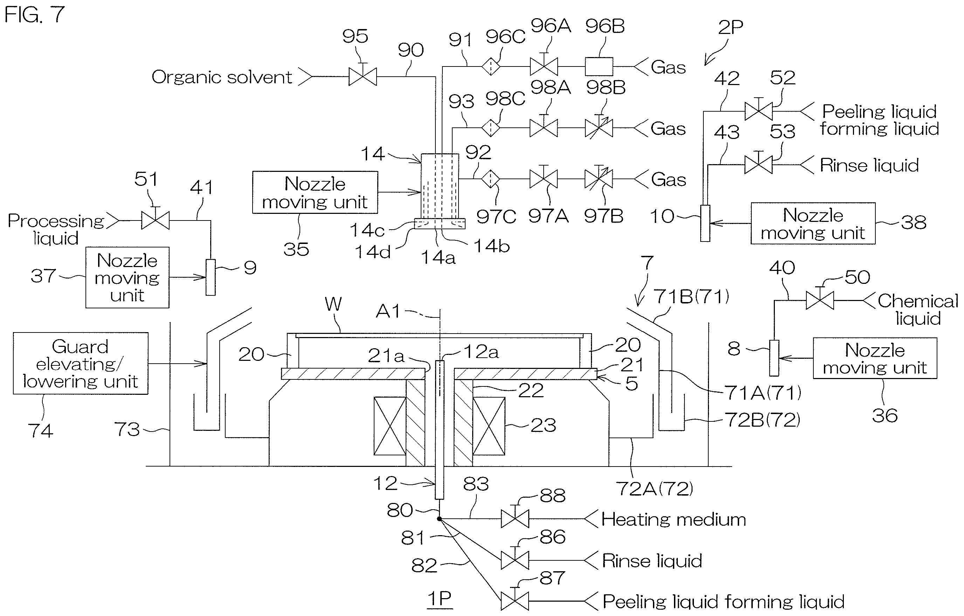

FIG. 7 is a schematic partial sectional view of the general configuration of a processing unit 2P included in a substrate processing apparatus 1P not forming part of the invention. Referring to FIG. 7, a main point of difference of the processing unit 2P with respect to the processing unit 2 (see FIG. 2) is that the processing unit 2P includes a fourth moving nozzle 14 in place of the facing member 6 and the central nozzle 11.

The fourth moving nozzle 14 is an example of the organic solvent supplying unit that supplies an organic solvent to the upper surface of the substrate W. The fourth moving nozzle 14 is also an example of the gas supplying unit that supplies a gas, such as nitrogen gas, etc., to the upper surface of the substrate W.

The fourth moving nozzle 14 is moved in a horizontal direction and in a vertical direction by a fourth nozzle moving unit 35. The fourth moving nozzle 14 is capable of moving between a center position and a home position (retreat position) in the horizontal direction.

When positioned at the center position, the fourth moving nozzle 14 faces the rotation center of the upper surface of the substrate W. When positioned at the home position, the fourth moving nozzle 14 does not face the upper surface of the substrate W and is positioned outside the processing cup 7 in plan view. By moving in the vertical direction, the fourth moving nozzle 14 can move close to the upper surface of the substrate W and retreat upward from the upper surface of the substrate W.

The fourth nozzle moving unit 35 has the same configuration as the first nozzle moving unit 36. That is, the fourth nozzle moving unit 35 includes, for example, a pivoting shaft (not shown) oriented along the vertical direction, an arm (not shown) that is coupled to the pivoting shaft and the fourth moving nozzle 14 and extends horizontally, and a pivoting shaft driving unit (not shown) that elevates, lowers, and pivots the pivoting shaft.

An organic solvent piping 90 that guides the organic solvent to the fourth moving nozzle 14 is connected to the fourth moving nozzle 14. When an organic solvent valve 95 interposed in the organic solvent piping 90 is opened, the organic solvent is discharged continuously from the fourth moving nozzle 14 toward the central region of the upper surface of the substrate W.

A plurality of gas pipings (a first gas piping 91, a second gas piping 92, and a third gas piping 93) each of which guide a gas to the fourth moving nozzle 14 are connected to the fourth moving nozzle 14. In the plurality of gas pipings (the first gas piping 91, the second gas piping 92 and the third gas piping 93) are respectively interposed gas valves (a first gas valve 96A, a second gas valve 97A, and a third gas valve 98A) for opening and closing the corresponding flow passages.

The fourth moving nozzle 14 has a central discharge port 14a that discharges the organic solvent, that is guided from the organic solvent piping 90, along the vertical direction. The fourth moving nozzle 14 has a linear flow discharge port 14b that discharges the gas, which is supplied from the first gas piping 91, rectilinearly along the vertical direction. Further, the fourth moving nozzle 14 has a horizontal flow discharge port 14c that discharges the gas, which is supplied from the second gas piping 92, radially along the horizontal direction to a periphery of the fourth moving nozzle 14. Also, the fourth moving nozzle 14 has an inclined flow discharge port 14d that discharges the gas, which is supplied from the third gas piping 93, radially along an obliquely downward direction to the periphery of the fourth moving nozzle 14.

A mass flow controller 96B configured to accurately adjust a flow rate of the gas flowing inside the first gas piping 91 is interposed in the first gas piping 91. The mass flow controller 96B has a flow control valve. Also, a variable flow valve 97B configured to adjust a flow rate of the gas flowing inside the second gas piping 92 is interposed in the second gas piping 92. Also, a variable flow valve 98B configured to adjust a flow rate of the gas flowing inside the third gas piping 93 is interposed in the third gas piping 93. Further, filters 96C, 97C, 98C configured to remove foreign objects are interposed in the first gas piping 91, the second gas piping 92, and the third gas piping 93, respectively.

As the organic solvent discharged from the fourth moving nozzle 14, the same organic solvent as the organic solvent discharged from the third tube 33 (see FIG. 2) can be cited. As the gas discharged from the fourth moving nozzle 14, the same gas as the gas discharged from the second tube 32 (see FIG. 2) can be cited.

Also, with the processing unit 2P, an upper rinse liquid piping 43 that guides a rinse liquid is connected to the third moving nozzle 10. When an upper rinse liquid valve 53 interposed in the upper rinse liquid piping 43 is opened, the rinse liquid is discharged continuously downward from the discharge port of the third moving nozzle 10.

The upper rinse liquid valve 53, the first gas valve 96A, the second gas valve 97A, the third gas valve 98A, the mass flow controller 96B, the variable flow valve 97B, the variable flow valve 98B, and the fourth nozzle moving unit 35 are controlled by the controller 3 (see FIG. 3).

The same substrate processing as that by the substrate processing apparatus 1 is enabled by using the substrate processing apparatus 1P. However, in the first rinsing step (step S3) and the second rinsing step (step S9), the rinse liquid is supplied from the third moving nozzle 10 to the upper surface of the substrate W.

Details of the (A) low solubility substance, the (B) dissolving and peeling liquid forming substance, the (C) solvent, and the (D) high solubility substance inside the processing liquid and details of the (F) dissolving and peeling liquid forming liquid shall now be described.

### <Processing Liquid>

As described above, by the processing liquid being dried on the substrate W and the (C) solvent being removed, the (A) low solubility substance is formed into a film. That is, the processing film 100 is formed. The (B) dissolving and peeling liquid forming substance and the (D) high solubility substance are not removed together with the (C) solvent and are left in the processing film 100. "Solidification" and "curing" are both a mode of "film formation." Also, the processing film 100 obtained from the processing liquid suffices to have a hardness of a degree enabling holding of the particles (the removal objects 103) and the (C) solvent is not required to be removed completely (for example, by vaporization). The processing liquid becomes the processing film while contracting gradually in accompaniment with volatilization of the (C) solvent. By "not removed together with the (C) solvent," it is meant that removal (e.g. evaporation or volatilization) of a very small amount with respect to the entirety is permissible. For example, removal of 0 ~ 10 mass % with respect to an original amount is permissible.

As described above, the processing film 100 holds the particles 103 on the substrate W and is removed by being peeled by the (F) dissolving and peeling liquid forming liquid. If the (B) dissolving and peeling liquid forming substance remains in the processing film 100, the (B) dissolving and peeling liquid forming substance is eluted into the (F) dissolving and peeling liquid forming liquid by the (F) dissolving and peeling liquid forming liquid being supplied to the substrate W. It is considered that thereby, the pH of the (F) dissolving and peeling liquid forming liquid increases and the dissolving and peeling liquid is formed (prepared). The (F) dissolving and peeling liquid forming liquid is thus not required to be an alkaline solution, such as ammonia water, and it is also considered that when the (B) dissolving and peeling liquid forming substance and the (D) high solubility substance remain in the film, portions that set off the peeling of the processing film 100 are formed.

### <Low Solubility Substance>

The (A) low solubility substance contains at least one of novolac, polyhydroxystyrene, polystyrene, a polyacrylic acid derivative, a polymaleic acid derivative, polycarbonate, a polyvinyl alcohol derivative, a polymethacrylic acid derivative, and a copolymer of a combination of the above. Preferably, the (A) low solubility substance contains at least one of novolac, polyhydroxystyrene, a polyacrylic acid derivative, polycarbonate, a polymethacrylic acid derivative, and a copolymer of a combination of the above. More preferably, the (A) low solubility substance contains at least one of novolac, polyhydroxystyrene, polycarbonate and a copolymer of a combination of the above. Novolac may be phenol novolac.

Obviously, the processing liquid according to the present invention may contain one or a combination of two or more of the above-described preferable examples as the (A) low solubility substance. For example, the (A) low solubility substance may contain both novolac and polyhydroxystyrene.

In a preferred mode, the (A) low solubility substance is formed into a film by being dried, and the film is peeled while still holding the particles and without being largely dissolved in the (F) dissolving and peeling liquid forming liquid (which may contain the dissolved (B) dissolving and peeling liquid forming substance) to be described below. A mode where a very small portion of the (A) low solubility substance is dissolved by the (F) dissolving and peeling liquid forming liquid is permissible.

Preferably, the (A) low solubility substance does not contain fluorine and/or silicon and more preferably it contains neither element.

Preferably, the copolymerization is random copolymerization or block copolymerization.

Although not intended to restrict the present invention, the compounds expressed by the following Chemical Formulae 1 to 7 can be cited as specific examples of the (A) low solubility substance. 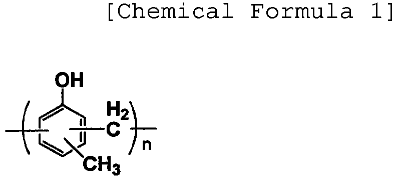 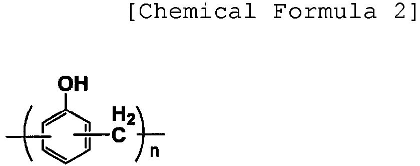 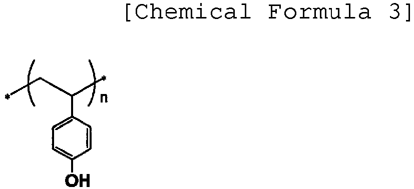 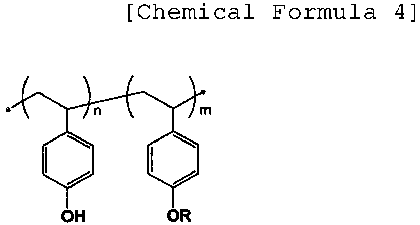 (Here, R signifies a substituent, such as a C₁₋₄ alkyl, etc.)

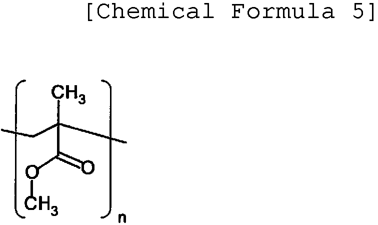

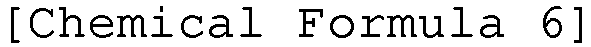

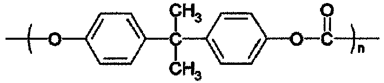

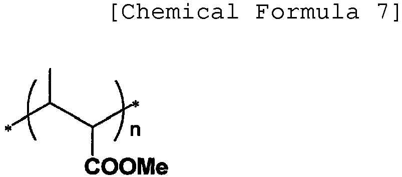

A weight average molecular weight (Mw) of the (A) low solubility substance is preferably 150 ~ 500,000.

The (A) low solubility substance can be obtained by synthesis. It can also be purchased. In the case of purchase, the following can be cited as examples of suppliers. The (A) low solubility substance can also be synthesized by a supplier such as to exhibit the effects of the present invention.
Novolac: Showa Kasei Kogyo Co., Ltd., Asahi Yukizai Corp., Gunei Chemical Industry Co., Ltd., Sumitomo Bakelite Co., Ltd.
Polyhydroxystyrene: Nippon Soda Co., Ltd., Maruzen Petrochemical Co., Ltd., Toho Chemical Industry Co., Ltd. Polyacrylic acid derivative: Nippon Shokubai Co., Ltd.
Polycarbonate: Sigma-Aldrich
Polymethacrylic acid derivative: Sigma-Aldrich

As a mode of the present invention, the amount of the (A) low solubility substance is 0.1 ~ 50 mass % in comparison to a total mass of the processing liquid. In other words, on basis of the total mass of the processing liquid as 100 mass %, the amount of the (A) low solubility substance is 0.1 ~ 50 mass %. That is, "in comparison to" can be reworded as "on basis of." The same applies in the present Specification, unless mentioned otherwise.

<Dissolving and Peeling Liquid Forming Substance>

The (B) dissolving and peeling liquid forming substance contains at least one of a primary amine, a secondary amine, a tertiary amine, and a quaternary ammonium salt (preferably at least one of a primary amine, a secondary amine, and a tertiary amine), and the (B) dissolving and peeling liquid forming substance contains a hydrocarbon. According to the invention, the (B) dissolving and peeling liquid forming substance remains in the processing film 100 formed from the processing liquid, and the (B) dissolving and peeling liquid forming substance is eluted into the (F) dissolving and peeling liquid forming liquid when the dissolving and peeling liquid peels the processing film 100. For this to take place, a boiling point at one atmospheric pressure of the alkaline component in the (B) is preferably 20 ~ 400°C.

Although not intended to restrict the type of the dissolving and peeling liquid forming substance, N-benzylethanolamine, diethanolamine, monoethanolamine, 2-(2-aminoethylamino)ethanol, 4,4'-diaminodiphenylmethane, 2-(butylamino)ethanol, 2-anilinoethanol, triethanolamine, ethylenediamine, diethylenetriamine, tris(2-aminoethyl)amine, and tris[2-(dimethylamino)ethyl]amine can be cited as preferable examples of (B).

Although not intended to restrict the type of the dissolving and peeling liquid forming substance, N,N,N',N'-tetrakis(2-hydroxyethyl)ethylenediamine and N,N,N',N'-tetraethylethylenediamine can be cited as preferable examples of (B).

Although not intended to restrict the type of the dissolving and peeling liquid forming substance, 1,4-diazabicyclo[2.2.2]octane and hexamethylenetetramine can be cited as specific examples of (B) having a cage type three-dimensional structure. Although not intended to restrict the present invention, 1,4,7,10-tetraazacyclododecane and 1,4,7,10,13,16-hexaazacyclooctadecane can be cited as specific examples of (B) having a planar cyclic structure.

Obviously, the processing liquid according to the present invention may contain one or a combination of two or more of the above-described preferable examples as the (B) dissolving and peeling liquid forming substance. For example, the (B) dissolving and peeling liquid forming substance may contain both N-benzylethanolamine and diethanolamine. Also, the (B) dissolving and peeling liquid forming substance may contain both N,N,N',N'-tetrakis(2-hydroxyethyl)ethylenediamine and 1,4-diazabicyclo[2.2.2]octane.

A molecular weight of the (B) dissolving and peeling liquid forming substance is preferably 50 ~ 500.

The (B) dissolving and peeling liquid forming substance can be obtained by synthesis or by purchase. In the case of purchase, the Sigma-Aldrich and Tokyo Chemical Industry Co., Ltd. can be cited as examples of suppliers.

As a mode of the present invention, the amount of the (B) dissolving and peeling liquid forming substance is preferably 1 ~ 100 mass % in comparison to the mass of the (A) low solubility substance inside the processing liquid.

### <Solvent>

The (C) solvent preferably contains an organic solvent. The (C) solvent has volatility. Having volatility means that the solvent is higher in volatility than water. A boiling point at one atmospheric pressure of the (C) solvent is preferably 50 ~ 200°C. It is permissible for the (C) solvent to contain a small amount of pure water. The amount of pure water contained in the (C) solvent is preferably not more than 30 mass % in comparison to the entire (C) solvent. Not containing pure water (0 mass %) is also a preferred mode. The pure water is preferably DIW.

As a preferred mode of the present invention, components (including an additive) contained in the processing liquid dissolve in the (C) solvent. The processing liquid that assumes this mode is considered to be satisfactory in embedding performance or film uniformity.

As the organic solvent contained in the (C), an alcohol, such as isopropanol (IPA) , etc.; an ethylene glycol monoalkyl ether, such as ethylene glycol monomethyl ether, ethylene glycol monoethyl ether, etc.; an ethylene glycol monoalkyl ether acetate, such as ethylene glycol monomethyl ether acetate, ethylene glycol monoethyl ether acetate, etc.; a propylene glycol monoalkyl ether, such as propylene glycol monomethyl ether (PGME), propylene glycol monoethyl ether (PGEE), etc.; a propylene glycol monoalkyl ether acetate, such as propylene glycol monomethyl ether acetate (PGMEA), propylene glycol monoethyl ether acetate, etc.; a lactic acid ester, such as methyl lactate, ethyl lactate (EL), etc.; an aromatic hydrocarbon, such as toluene, xylene, etc.; a ketone, such as methyl ethyl ketone, 2-heptanone, cyclohexanone, etc.; an amide, such as N,N-dimethylacetamide, N-methylpyrrolidone, etc.; or a lactone, such as γ-butyrolactone, etc., can be cited. These organic solvents can be used alone or two or more types can be mixed and used.

As a preferred mode, the organic solvent contained in the (C) solvent is selected from IPA, PGME, PGEE, EL, PGMEA, and any combination thereof. If the organic solvent is a combination of two types, a volume ratio thereof is preferably 20:80 ~ 80:20.

In comparison to the entire mass of the processing liquid, the amount of the (C) solvent is 0.1 ~ 99.9 mass %.

### <High Solubility Substance>

The (D) high solubility substance contains a hydrocarbon and further contains a hydroxy group (-OH) and/or a carbonyl group (-C(=O)-). If the (D) high solubility substance is a polymer, one type of constituent unit contains a hydrocarbon in each unit and further contains a hydroxy group and/or a carbonyl group. As the carbonyl group, carboxylic acid (-COOH), aldehyde, ketone, ester, amide, and enone can be cited, and carboxylic acid is preferable.

As described above, the (D) high solubility substance remains in the processing film formed on the substrate when the processing liquid is dried. In the dissolving and peeling of the processing film by the (F) dissolving and peeling liquid forming liquid, the (D) high solubility substance gives rise to the portions that induce the peeling of the processing film. For this to take place, it is preferable for the (D) high solubility substance to be that which is higher in solubility in the (F) dissolving and peeling liquid forming liquid than the (A) low solubility substance is used.

As a mode of the (D) high solubility substance that contains ketone as the carbonyl group, a cyclic hydrocarbon can be cited. As specific examples, 1,2-cyclohexanedione and 1, 3-cyclohexanedione can be cited.

Although not intended to restrict the scope of the claims, 2,2-bis(4-hydroxyphenyl)propane, 2,2'-methylenebis(4-methylphenol), 2,6-bis[(2-hydroxy-5-methylphenyl)methyl]-4-methylphenol, 1,3-cyclohexanediol, 4,4'-dihydroxybiphenyl, 2,6-naphthalenediol, 2,5-di-tert-butylhydroquinone, and 1,1,2,2-tetrakis(4-hydroxyphenyl)ethane can be cited as preferable examples of (D). These may be obtained by polymerization or condensation.

Although not intended to restrict the scope of the claims, 3,6-dimethyl-4-octyne-3,6-diol and 2,5-dimethyl-3-hexyne-2,5-diol can be cited as preferable examples of (D). As other modes, 3-hexyne-2,5-diol, 1,4-butynediol, 2,4-hexadiyne-1,6-diol, 1,4-butanediol, cis-1,4-dihydroxy-2-butene, and 1,4-benzenedimethanol can also be cited as preferable examples of (D).

Although not intended to restrict the scope of the claims, polymers of acrylic acid, maleic acid, or combinations thereof can be cited as preferable examples of the (D) polymer. Polyacrylic acids and maleic acid/acrylic acid copolymers are more preferable examples.

In the case of copolymerization, random copolymerization or block copolymerization is preferable, and random copolymerization is more preferable.

Obviously, the processing liquid may contain one or a combination of two or more of the above-described preferable examples as the (D) high solubility substance. For example, the (D) high solubility substance may contain both 2,2-bis(4-hydroxyphenyl)propane and 3,6-dimethyl-4-octyne-3,6-diol.

A molecular weight of the (D) high solubility substance may be 80 ~ 10,000. If the (D) high solubility substance is a resin, a polymeride, or a polymer, the molecular weight is expressed by the weight average molecular weight (Mw) .

The (D) high solubility substance can be obtained by synthesis or purchase. As suppliers, Sigma-Aldrich, Tokyo Chemical Industry Co., Ltd., and Nippon Shokubai Co., Ltd. can be cited.

As a mode of the present invention, the amount of the (D) high solubility substance is preferably 1 ~ 100 mass % in comparison to the mass of the (A) low solubility substance inside the processing liquid.

### <Other Additive>

The processing liquid of the present invention may further contain (E) another additive. The (E) other additive may include a surfactant, an antibacterial agent, a bactericide, an antiseptic, an antifungal agent, or a base (a surfactant is preferable) or may include a combination of any of the above.

The amount of the (E) other additive (the sum amount in the case of a plurality of additives) is preferably 0 ~ 10 mass % in comparison to the mass of the (A) low solubility substance inside the processing liquid. The processing liquid does not have to contain (E) another additive (0 mass %).

### <Dissolving and Peeling Liquid Forming Liquid>

As described above, the processing liquid supplied to the substrate W is dried and by the (C) solvent thereby being removed, the (A) low solubility substance is formed into a film. That is, the processing film is formed. The (B) dissolving and peeling liquid forming substance and the (D) high solubility substance remain in the processing film without being removed together with the (C) solvent. The processing film is capable of holding the particles present on the substrate and is removed by the (F) dissolving and peeling liquid forming liquid while still holding the particles.

Here, the (F) dissolving and peeling liquid forming liquid is preferably neutral or weakly acidic. The (F) dissolving and peeling liquid forming liquid is preferably 4 ~ 7 in pH, more preferably 5 ~ 7 in pH, and even more preferably 6 ~ 7 in pH. For measurement of the pH, performing measurement upon degassing is preferable to avoid influences due to dissolution of carbon dioxide in air.

According to the invention, the dissolving and peeling forming liquid is pure water, carbonated water, or ammonia water of dilute concentration.

Preferably, the (F) dissolving and peeling liquid forming liquid contains pure water. As described above, the processing liquid of the present invention contains the (B) dissolving and peeling liquid forming substance by which the dissolving and peeling liquid is formed (prepared) through elution into the (F) dissolving and peeling liquid forming liquid and increasing the pH of the (F) dissolving and peeling liquid forming liquid. A large portion of the (F) dissolving and peeling liquid forming liquid may thus be pure water. In comparison to a total mass of the (F) dissolving and peeling liquid forming liquid, the amount of pure water contained in the (F) is preferably 80 ~ 100 mass %, more preferably 90 ~ 100 mass %, even more preferably 95 ~ 100 mass %, and yet even more preferably 99 ~ 100 mass %. A mode where the (F) dissolving and peeling liquid forming liquid is constituted of just pure water (100 mass %) is also preferable.

When the processing liquid is constituted of the (A) low solubility substance, the (B) dissolving and peeling liquid forming substance, the (C) solvent, and the (D) high solubility substance, conditions of forming of the processing film and conditions of dissolving and peeling of the processing film from a substrate can also be described as follows.

By the processing liquid being dropped and dried on the substrate W to which the particles are attached, the low solubility substance (polymer) is formed into the film. By the low solubility substance being formed into the film, the processing film is formed. The dissolving and peeling liquid forming substance (alkaline component) remains in the processing film. Thereafter, the dissolving and peeling liquid forming liquid is supplied to the processing film and the alkaline component becomes eluted into the dissolving and peeling liquid forming liquid. It is considered that by the elution of the alkaline component, the pH of the dissolving and peeling liquid forming liquid in the vicinity of the processing film increases and the dissolving and peeling liquid dd that peels the processing film from the substrate W is formed (prepared). Also, the high solubility substance (crack promoting component) remains in the processing film. The crack promoting component becomes eluted into the dissolving and peeling liquid forming liquid/peeling liquid and marks (void holes) resulting from the elution of the crack promoting component are formed in the processing film. The marks formed by the elution of the crack promoting component induce the peeling of the processing film and cracks spread with these as the starting points. The processing film that is split by the spreading of the cracks is removed from the substrate W while still holding the particles.

It is considered that, in the removal (peeling) of the processing film (particle holding layer) by the (F) dissolving and peeling liquid forming liquid, the (B) dissolving and peeling liquid forming substance and the (D) high solubility substance that remain in the processing film give rise to the portions that induce the peeling of the film. It is thus preferable for the (B) dissolving and peeling liquid forming substance and the (D) high solubility substance to be those that are higher in solubility in the (F) dissolving and peeling liquid forming liquid than the (A) low solubility substance. The solubility can be evaluated by a known method. For example, the solubility can be determined by checking that the (A) or (B) described above is dissolved by adding the (A) or (B) at 100 ppm to pure water in a flask and then capping and shaking the flask for 3 hours by a shaker under conditions of 20 ~ 35°C (more preferably 25±2°C). For the evaluation of solubility, the pure water may be changed to an alkaline liquid (for example, ammonia water of 5.0 mass %).

According to the present invention, the processing film is removed from the substrate while still holding the particles and without being completely dissolved by the (F) dissolving and peeling liquid forming liquid. It is considered that the processing film is removed, for example, upon being put in a state of being cut finely by the "portions that induce the peeling."

The present invention shall now be described by way of various examples. The processing liquid and the dissolving and peeling liquid forming liquid are not restricted to just these examples.

### Preparation of Patterned Substrate

A KrF resist composition (AZ DX-6270P, Merck Performance Materials Ltd., hereinafter referred to as "MPM Ltd.") is dropped onto an 8-inch Si substrate and spin-coated on the substrate at 1500 rpm. The substrate is soft-baked at 120°C for 90 seconds. The substrate is then exposed at 20 mJ/cm² using a KrF stepper (FPA-3000 EX5, Canon) and subject to PEB (post exposure baking) at 130°C for 90 seconds and developed with a developing fluid (AZ MIF-300, MPM Ltd.). A line/space resist pattern having a pitch of 360 nm and a duty ratio of 1:1 is thereby obtained. The resist pattern is used as an etching mask to etch the substrate with a dry etching apparatus (NE-5000N, ULVAC). Thereafter, the substrate is cleaned with a stripper (AZ 400T, MPM Ltd.) to peel the resist pattern and a resist residue. A patterned substrate having a pattern with a pitch of 360 nm, a duty ratio of 1:1, and a line height of 150 nm is thereby prepared.

### Preparation of Bare Substrate

An 8-inch Si substrate is used.

### Preparation of Evaluation Substrate

Particles are attached to the patterned substrate and the bare substrate described above. As experimental particles, ultra-high purity colloidal silica (PL-10H, Fuso Chemical Co., Ltd., average primary particle diameter: 90 nm) is used. 50 mL of a silica microparticle composition is dropped and rotation at 500 rpm is performed for 5 seconds to perform coating. Thereafter, rotation at 1000 rpm is performed for 30 seconds to spin-dry a solvent of the silica microparticle composition. An evaluation substrate is thereby obtained.

### Comparison Test of Presence/Non-Presence of Respective Components in Processing Liquid

5 g of novolac (Mw: approximately 5,000; the (A) low solubility substance) is added to 95 g of isopropanol (the (C) solvent). The mixture is stirred with a stirrer for 1 hour and a liquid with which the concentration of the (A) low solubility substance is 5 mass % is obtained. 2.5 g each of diethanolamine (the (B) dissolving and peeling liquid forming substance) and 3, 6-dimethyl-4-octyne-3, 6-diol (Tokyo Chemical Industry Co., Ltd., hereinafter referred to as "TCI Co., Ltd."; the (D) high solubility substance) are added to the liquid. The mixture is stirred with a stirrer for 1 hour. The liquid is then filtered with Optimizer UPE (Nihon Entegris G.K.). A processing liquid containing the (A), the (B), and the (D) is thereby obtained.

A processing liquid containing the (A) and the (B) is obtained by performing the same with the exception of not adding the (D) component.

A processing liquid containing the (A) and the (D) is obtained by performing the same with the exception of not adding the (B) component.

A processing liquid containing the (B) and the (D) is obtained by performing the same with the exception of not adding the (A) component.

Using Coater-Developer RF3 (Sokudo Co., Ltd.), 10 cc of the respective processing liquids are dropped onto the respective evaluation substrates and rotation at 1,500 rpm is performed for 60 seconds to perform coating and drying. While rotating each substrate at 100 rpm, DIW is dropped for 10 seconds to cover the entire substrate with DIW and this state is kept for 20 seconds. The substrate is dried by rotating the substrate at 1,500 rpm. If a film is present, the film is peeled and removed by the rotation.

Residual particle amounts of the substrates are compared. A bright field defect inspection apparatus (UVision 4, AMAT Ltd.) is used to evaluate the patterned substrates and a dark field defect inspection apparatus (LS-9110, Hitachi High-Technologies Corporation) is used to evaluate the bare substrates.

### Preparation Example 1 of Cleaning Liquid 1

5 g of novolac (Mw: approximately 5,000; the (A) low solubility substance) are added to 95 g of isopropanol (the (C) solvent). The mixture is stirred with a stirrer for 1 hour and a liquid with which the concentration of the (A) low solubility substance is 5 mass % is obtained. 2.5 g each of N-benzylethanolamine (TCI Co., Ltd.; the (B) dissolving and peeling liquid forming substance) and 2,2-bis(4-hydroxyphenyl)propane (TCI Co., Ltd.; the (D) high solubility substance) are added to the liquid. The mixture is stirred with a stirrer for 1 hour. The liquid is then filtered with Optimizer UPE (Nihon Entegris G.K.). A cleaning liquid 1 is thereby obtained. Results thereof are indicated in Table 1.

In Tables 1 to 3 below, the novolac is abbreviated as A1, N-benzylethanolamine is abbreviated as B1, isopropanol is abbreviated as IPA, and 2, 2-bis (4-hydroxyphenyl) propane is abbreviated as D1. Also, the numerals in parentheses in the (A) column each signify the concentration (mass %) when the (A) low solubility substance is added to the (C) solvent. The numerals in parentheses in the (B) column each signify the concentration (mass %) in comparison to the (A) low solubility substance when the (B) dissolving and peeling liquid forming substance is added to the corresponding liquid. The numerals in parentheses in the (D) column each signify the concentration (mass %) in comparison to the (A) low solubility substance when the (D) high solubility substance is added to the corresponding liquid.

### [Table 1]

**Table 1**

| | (A) | (B) | (D) | (C) Solvent | Removal evaluation | Removal evaluation |
|---|---|---|---|---|---|---|
| | | | | | Patterned substrate | Bare substrate |
| Cleaning liquid 1 | A1 (5%) | B1 (1%) | D1 (1%) | IPA | A | A |
| Cleaning liquid 2 | A1 (5%) | B1 (10%) | D1 (1%) | IPA | AA | AA |
| Cleaning liquid 3 | A1 (5%) | B1 (50%) | D1 (1%) | IPA | AA | AA |
| Cleaning liquid 4 | A1 (5%) | B1 (100%) | D1 (1%) | IPA | A | AA |
| Cleaning liquid 5 | A1 (5%) | B1 (1%) | D1 (10%) | IPA | AA | A |
| Cleaning liquid 6 | A1 (5%) | B1 (10%) | D1 (10%) | IPA | AA | AA |
| Cleaning liquid 7 | A1 (5%) | B1 (50%) | D1 (10%) | IPA | AA | AA |
| Cleaning liquid 8 | A1 (5%) | B1 (100%) | D1 (10%) | IPA | A | A |
| Cleaning liquid 9 | A1 (5%) | B1 (1%) | D1 (50%) | IPA | A | AA |
| Cleaning liquid 10 | A1 (5%) | B1 (10%) | D1 (50%) | IPA | A | AA |

### [Table 2]

**Table 2**

| | (A) | (B) | (D) | (C) Solvent | Removal evaluation | Removal evaluation |
|---|---|---|---|---|---|---|
| | | | | | Patterned substrate | Bare substrate |
| Cleaning liquid 11 | A2 (5%) | B2 (50%) | D2 (50%) | PGEE | AA | AA |
| Cleaning liquid 12 | A3 (5%) | B2 (50%) | D2 (50%) | PGEE | AA | AA |
| Cleaning liquid 13 | A4 (5%) | B2 (50%) | D2 (50%) | PGEE | AA | AA |
| Cleaning liquid 14 | A5 (5%) | B2 (50%) | D2 (50%) | PGEE | AA | AA |
| Cleaning liquid 15 | A6 (5%) | B2 (50%) | D2 (50%) | PGEE | A | AA |
| Cleaning liquid 16 | A7 (5%) | B2 (50%) | D2 (50%) | PGEE | AA | AA |
| Cleaning liquid 17 | A8 (5%) | B2 (50%) | D2 (50%) | PGEE | AA | AA |
| Cleaning liquid 18 | A9 (5%) | B2 (50%) | D2 (50%) | PGEE | A | AA |

### [Table 3]

**Table 3**

| | (A) | (B) | (D) | (C) Solvent | Removal evaluation | Removal evaluation |
|---|---|---|---|---|---|---|
| | | | | | Patterned substrate | Bare substrate |
| Cleaning liquid 19 | A10 (5%) | B2 (50%) | D3 (50%) | EL | AA | AA |
| Cleaning liquid 20 | A10 (5%) | B2 (50%) | D4 (50%) | EL | AA | AA |
| Cleaning liquid 21 | A10 (5%) | B2 (50%) | D5 (50%) | EL | AA | AA |
| Cleaning liquid 22 | A10 (5%) | B3 (50%) | D2 (50%) | EL | AA | AA |
| Cleaning liquid 23 | A10 (5%) | B4 (50%) | D2 (50%) | EL | AA | AA |
| Cleaning liquid 24 | A10 (5%) | B5 (50%) | D2 (50%) | EL | AA | AA |
| Cleaning liquid 25 | A10 (5%) | B6 (50%) | D2 (50%) | EL | AA | AA |
| Cleaning liquid 26 | A10 (5%) | B7 (50%) | D2 (50%) | EL | AA | AA |
| Cleaning liquid 27 | A10 (5%) | B8 (50%) | D2 (50%) | EL | AA | AA |

The following abbreviations are used in Table 1 to Table 3 above.
Phenol novolac (Mw: approximately 10,000) is abbreviated as A2,
phenol novolac (Mw: approximately 100,000) is abbreviated as A3,
polyhydroxystyrene (Mw: approximately 1,000) is abbreviated as A4,
polyhydroxystyrene (Mw: approximately 10,000) is abbreviated as A5,
polyhydroxystyrene (Mw: approximately 100,000) is abbreviated as A6,
a polyacrylic acid derivative (Mw: approximately 1, 000) having the structure shown in Chemical Formula 8 below is abbreviated as A7, 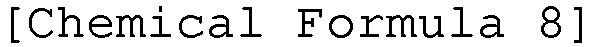 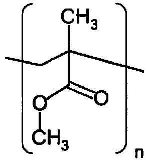
a polyacrylic acid derivative (Mw: approximately 10,000) having the same repeating unit as the above is abbreviated as A8,
a polyacrylic acid derivative (Mw: approximately 100,000) having the same repeating unit as the above is abbreviated as A9,
polymethyl methacrylate (Mw: approximately 5,000) is abbreviated as A10,
diethanolamine is abbreviated as B2,
monoethanolamine is abbreviated as B3,
2-(2-aminoethylamino)ethanol is abbreviated as B4,
4,4'-diaminophenylmethane is abbreviated as B5,
1,4-diazabicyclo[2.2.2]octane is abbreviated as B6,
hexamethylenetetramine is abbreviated as B7,
2-(butylamino)ethanol is abbreviated as B8,
3,6-dimethyl-4-octyne-3,6-diol is abbreviated as D2,
polyacrylic acid (Mw: approximately 1,000) is abbreviated as D3,
polyacrylic acid (Mw: approximately 10,000) is abbreviated as D4, and
a maleic acid/acrylic acid copolymer (Mw: approximately 3,000) having the Chemical Formula 9 below is abbreviated as D5.

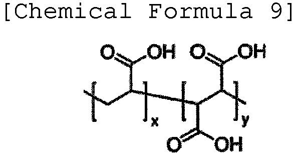

### Preparation Examples 1 to 27 of Cleaning Liquids 1 to 27

The cleaning liquids 2 to 27 are prepared in the same manner as the preparation example 1 with the exceptions of using the substances indicated in Table 1 to Table 3 as the (A) low solubility substances, the (B) dissolving and peeling liquid forming substances, the (C) solvents, and the (D) high solubility substances and preparing the liquids such as to achieve the concentrations indicated in Table 1 to Table 3.

### Evaluation of Residual Particle Amounts of Cleaning Liquids 1 to 27

Evaluation substrates prepared as described in the above description of preparation of evaluation substrates are used.

Using Coater-Developer RF3 (Sokudo Co., Ltd.), 10 cc of the respective processing liquids are dropped onto the respective evaluation substrates and rotation at 1,500 rpm is performed for 60 seconds to perform coating and drying. While rotating each substrate at 100 rpm, DIW is dropped for 10 seconds to cover the entire substrate with DIW and this state is kept for 20 seconds. The substrate is dried by rotating the substrate at 1,500 rpm. If a film is present, the film is peeled and removed by the rotation.

The residual particle amounts of the substrates are compared. The bright field defect inspection apparatus (UVision 4, AMAT Ltd.) is used to evaluate the patterned substrates and the dark field defect inspection apparatus (LS-9110, Hitachi High-Technologies Corporation) is used to evaluate the bare substrates.

Coating conditions and film removal conditions are checked and remaining numbers of particles are counted and evaluated according to the following criteria. The evaluation results are indicated in Table 1 to Table 3.
AA: ≤10 particles
A: >10 particles and ≤100 particles
B: >100 particles and ≤1,000 particles
C: >1000 particles
D: The film is not uniformly coated or the film is not removed.

### Other Modifications

The present invention is not restricted to the preferred embodiments described above and can be implemented in yet other modes.

For example, unlike in the substrate processing in the preferred embodiments described above, the chemical liquid supplying step (step S2), the first rinsing step (step S3), and the first organic solvent supplying step (step S4) may be omitted.

Also, in the substrate processing in the preferred embodiments described above, the solvent of the processing liquid evaporates due to heating of the substrate W by the heating medium in the processing film forming step (step S6 and step S7). However, the heating of the substrate W is not restricted to that by the supply of the heating medium and may instead be performed, for example, by a heater, etc. (not shown) incorporated in the spin base 21 or the facing member 6. In this case, the heater functions as the substrate heating unit and the evaporating unit (evaporation promoting unit).

Also, in the substrate processing in the preferred embodiments described above, the second rinsing step (step S9) is executed after the peeling/removing step (step S8). However, it is also possible to omit the second rinsing step.

In detail, if pure water is used as the dissolving and peeling liquid forming liquid in the peeling/removing step and the processing film 100 is expelled outside the substrate W by the pure water as the dissolving and peeling liquid forming liquid, there is no need to wash way the dissolving and peeling liquid forming liquid and therefore, the second rinsing step can be omitted. There is also no need to execute the second rinsing step if the dissolving and peeling liquid forming liquid supplied to the substrate W in the peeling/removing step and the organic solvent (residue removing liquid) supplied to the substrate W in the second organic solvent supplying step (step S10) executed after the second rinsing step have compatibility.

Also, the heating of the substrate W does not necessarily have to be performed to form the processing film 100. That is, if the solvent volatilizes sufficiently in the film thinning step (step S6), the subsequent heating step (step S7) does not have to be executed. In particular, if remaining of the solvent in the interior of the processing film 100 is permissible, the solvent can readily be evaporated to a desired degree even if the substrate W is not heated.

The scope of the present invention, therefore, is to be determined solely by the following claim.

## Claims

1. A substrate processing method comprising:
a processing liquid supplying step of supplying a processing liquid having a solute and a solvent to a surface of a substrate (W);
a processing film forming step of solidifying or curing the processing liquid supplied to the surface of the substrate (W) to form, on the surface of the substrate (W), a processing film (100) that holds an object (103) to be removed present on the surface of the substrate (W);
a dissolving and peeling step of supplying a dissolving and peeling liquid forming liquid to the surface of the substrate (W) to put the dissolving and peeling liquid forming liquid in contact with the processing film (100) and form a dissolving and peeling liquid so as to partially dissolve the processing film (100) and peel the processing film (100), in the state of holding the object (103) to be removed, from the surface of the substrate (W) by the dissolving and peeling liquid; and
a removing step of continuing the supply of the dissolving and peeling liquid forming liquid, after the peeling of the processing film (100) to wash away and remove the processing film (100) from the surface of the substrate (W) in the state where the object (103) to be removed is held by the processing film,
wherein the solute has a dissolving and peeling liquid forming substance (112),
the processing film forming step includes a step of forming the processing film (100) having the dissolving and peeling liquid forming substance (112) in a solid state,
the dissolving and peeling step includes a step of dissolving the dissolving and peeling liquid forming substance (112) that is in the solid state inside the processing film (100) in the dissolving and peeling liquid forming liquid supplied to the surface of the substrate (W) to form the dissolving and peeling liquid,
the dissolving and peeling liquid is an alkaline liquid,
the dissolving and peeling liquid forming liquid is pure water, carbonated water, or ammonia water of dilute concentration,
the dissolving and peeling step includes a penetrating hole forming step of supplying the dissolving and peeling liquid forming liquid to the surface of the substrate (W) to dissolve the processing film (100) partially and form a penetrating hole (102) in the processing film (100),
the solute has a high solubility substance and a low solubility substance that is lower in solubility in at least one of the dissolving and peeling liquid and the dissolving and peeling liquid forming liquid than the high solubility substance,
the processing film forming step includes a step of forming the processing film (100) having the high solubility substance (110) and the low solubility substance (111) in solid states, and
the penetrating hole forming step includes a step of dissolving the high solubility substance (110) that is in the solid state inside the processing film (100) in at least one of the dissolving and peeling liquid formed on the substrate (W) and the dissolving and peeling liquid forming liquid supplied to the surface of the substrate (W) to form the penetrating hole (102) in the processing film (100).

## Patentansprüche

1. Substratbearbeitungsverfahren, umfassend:
einen Bearbeitungsflüssigkeitszuführschritt des Zuführens einer Bearbeitungsflüssigkeit, die einen gelösten Stoff und ein Lösungsmittel aufweist, zu einer Oberfläche eines Substrats (W);
einen Bearbeitungsfilmbildungsschritt des Verfestigens oder Härtens der Bearbeitungsflüssigkeit, die der Oberfläche des Substrats (W) zugeführt wird, um auf der Oberfläche des Substrats (W) einen Bearbeitungsfilm (100) zu bilden, der ein zu entfernendes Objekt (103) hält, das auf der Oberfläche des Substrats (W) vorhanden ist;
einen Löse- und Ablöseschritt des Zuführens einer Löse- und Ablöseflüssigkeitsbildungsflüssigkeit zu der Oberfläche des Substrats (W), um die Löse- und Ablöseflüssigkeitsbildungsflüssigkeit mit dem Bearbeitungsfilm (100) in Kontakt zu bringen und eine Löse- und Ablöseflüssigkeit zu bilden, um den Bearbeitungsfilm (100) teilweise zu lösen und den Bearbeitungsfilm (100) in dem Zustand des Haltens des zu entfernenden Objekts (103) von der Oberfläche des Substrats (W) durch die Löse- und Ablöseflüssigkeit abzulösen; und
einen Entfernungsschritt des Fortsetzens der Zuführung der Löse- und Ablöseflüssigkeitsbildungsflüssigkeit nach dem Ablösen des Bearbeitungsfilms (100), um den Bearbeitungsfilm (100) von der Oberfläche des Substrats (W) in dem Zustand, in dem das zu entfernende Objekt (103) durch den Bearbeitungsfilm gehalten wird, wegzuwaschen und zu entfernen,
wobei der gelöste Stoff eine Löse- und Ablöseflüssigkeitsbildungssubstanz (112) aufweist,
der Bearbeitungsfilmbildungsschritt einen Schritt des Bildens des Bearbeitungsfilms (100), der die Löse- und Ablöseflüssigkeitsbildungssubstanz (112) aufweist, in einem festen Zustand beinhaltet,
der Löse- und Ablöseschritt einen Schritt des Lösens der Löse- und Ablöseflüssigkeitsbildungssubstanz (112), die sich in dem festen Zustand innerhalb des Bearbeitungsfilms (100) befindet, in der Löse- und Ablöseflüssigkeitsbildungsflüssigkeit, die der Oberfläche des Substrats (W) zugeführt wird, beinhaltet, um die Löse- und Ablöseflüssigkeit zu bilden,
die Löse- und Ablöseflüssigkeit eine alkalische Flüssigkeit ist,
die Löse- und Ablöseflüssigkeitsbildungsflüssigkeit reines Wasser, kohlensäurehaltiges Wasser oder Ammoniakwasser mit verdünnter Konzentration ist,
der Löse- und Ablöseschritt einen Durchdringungslochbildungsschritt des Zuführens der Löse- und Ablöseflüssigkeitsbildungsflüssigkeit zu der Oberfläche des Substrats (W) beinhaltet, um den Bearbeitungsfilm (100) teilweise zu lösen und ein Durchdringungsloch (102) in dem Bearbeitungsfilm (100) zu bilden,
der gelöste Stoff eine Substanz mit hoher Löslichkeit und eine Substanz mit niedriger Löslichkeit aufweist, die in mindestens einer von der Löse- und Ablöseflüssigkeit und der Löse- und Ablöseflüssigkeitsbildungsflüssigkeit eine geringere Löslichkeit aufweist als die Substanz mit hoher Löslichkeit,
der Bearbeitungsfilmbildungsschritt einen Schritt des Bildens des Bearbeitungsfilms (100), der die Substanz mit hoher Löslichkeit (110) und die Substanz mit niedriger Löslichkeit (111) aufweist, in festen Zuständen beinhaltet, und
der Durchdringungslochbildungsschritt einen Schritt des Lösens der Substanz mit hoher Löslichkeit (110), die sich in dem festen Zustand innerhalb des Bearbeitungsfilms (100) befindet, in mindestens einer von der Löse- und Ablöseflüssigkeit, die auf dem Substrat (W) gebildet ist, und der Löse- und Ablöseflüssigkeitsbildungsflüssigkeit, die der Oberfläche des Substrats (W) zugeführt wird, beinhaltet, um das Durchdringungsloch (102) in dem Bearbeitungsfilm (100) zu bilden.

## Revendications

1. Méthode de traitement d'un substrat comprenant:
une étape d'alimentation en liquide de traitement consistant à fournir un liquide de traitement comprenant un soluté et un solvant à une surface d'un substrat (W);
une étape de formation d'un film de traitement consistant à solidifier ou à durcir le liquide de traitement fourni à la surface du substrat (W) afin de former, sur la surface du substrat (W), un film de traitement (100) qui retient un objet (103) à éliminer présent sur la surface du substrat (W);
une étape de dissolution et de pelage consistant à fournir un liquide formant un liquide de dissolution et de pelage à la surface du substrat (W) afin de mettre le liquide formant un liquide de dissolution et de pelage en contact avec le film de traitement (100) et de former un liquide de dissolution et de pelage de manière à dissoudre partiellement le film de traitement (100) et à peler le film de traitement (100), dans l'état de maintien de l'objet (103) à retirer, de la surface du substrat (W) par le liquide de dissolution et de pelage; et
une étape d'enlèvement consistant à poursuivre l'alimentation en liquide formant le liquide de dissolution et de pelage, après le pelage du film de traitement (100), afin de laver et d'enlever le film de traitement (100) de la surface du substrat (W) dans l'état où l'objet (103) à retirer est maintenu par le film de traitement,
le soluté a une substance formant un liquide de dissolution et de pelage (112),
l'étape de formation du film de traitement comprend une étape consistant à former le film de traitement (100) contenant la substance formant un liquide de dissolution et de pelage (112) à l'état solide,
l'étape de dissolution et de pelage comprend une étape consistant à dissoudre la substance formant un liquide de dissolution et de pelage (112) qui se trouve à l'état solide à l'intérieur du film de traitement (100) dans le liquide formant un liquide de dissolution et de pelage fourni à la surface du substrat (W) afin de former le liquide de dissolution et de pelage,
le liquide de dissolution et de pelage est un liquide alcalin,
le liquide formant le liquide de dissolution et de pelage est de l'eau pure, de l'eau carbonatée ou de l'eau ammoniacale de concentration diluée,
l'étape de dissolution et de pelage comprend une étape de formation de trous de pénétration consistant à fournir le liquide formant le liquide de dissolution et de pelage à la surface du substrat (W) afin de dissoudre partiellement le film de traitement (100) et de former un trou de pénétration (102) dans le film de traitement (100),
le soluté comprend une substance à haute solubilité et une substance à faible solubilité qui est moins soluble dans au moins l'un parmi le liquide de dissolution et de pelage et le liquide formant le liquide de dissolution et de pelage que la substance à haute solubilité,
l'étape de formation du film de traitement comprend une étape consistant à former le film de traitement (100) ayant la substance à haute solubilité (110) et la substance à faible solubilité (111) à l'état solide, et
l'étape de formation de trous de pénétration comprend une étape consistant à dissoudre la substance à haute solubilité (110) qui se trouve à l'état solide à l'intérieur du film de traitement (100) dans au moins l'un parmi le liquide de dissolution et de pelage formé sur le substrat (W) et le liquide de dissolution et de pelage fourni à la surface du substrat (W) afin de former le trou de pénétration (102) dans le film de traitement (100).
